(19) Europäisches Patentamt / European Patent Office / Office européen des brevets

(11) **EP 4 003 634 B1**

(12) **EUROPÄISCHE PATENTSCHRIFT**

(45) Veröffentlichungstag und Bekanntmachung des Hinweises auf die Patenterteilung:
**05.03.2025 Patentblatt 2025/10**

(21) Anmeldenummer: **20734492.0**

(22) Anmeldetag: **19.06.2020**

(51) Internationale Patentklassifikation (IPC):
**B23K 26/06** (2014.01)     **B23K 26/067** (2006.01)
**B23K 26/352** (2014.01)     **G03F 7/20** (2006.01)

(52) Gemeinsame Patentklassifikation (CPC):
**B23K 26/0608; B23K 26/0676; B23K 26/352**

(86) Internationale Anmeldenummer:
**PCT/EP2020/067141**

(87) Internationale Veröffentlichungsnummer:
**WO 2021/013447 (28.01.2021 Gazette 2021/04)**

(54) **LASERBEARBEITUNGSVORRICHTUNG MIT EINER OPTISCHEN ANORDNUNG, DIE EINEN STRAHLTEILER AUFWEIST**

LASER PROCESSING DEVICE HAVING AN OPTICAL ARRANGEMENT WHICH COMPRISES A BEAM SPLITTER

DISPOSITIF D'USINAGE AU LASER COMPRENANT UN ENSEMBLE OPTIQUE POURVU D'UN SÉPARATEUR DE FAISCEAU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.07.2019 DE 102019119790**

(43) Veröffentlichungstag der Anmeldung:
**01.06.2022 Patentblatt 2022/22**

(73) Patentinhaber: **4JET microtech GmbH
52477 Alsdorf (DE)**

(72) Erfinder: **DYCK, Tobias
52066 Aachen (DE)**

(74) Vertreter: **Dilg, Haeusler, Schindelmann
Patentanwaltsgesellschaft mbH
Leonrodstraße 58
80636 München (DE)**

(56) Entgegenhaltungen:
**DE-A1- 19 623 352       DE-A1- 19 623 352
JP-A- 2006 110 587       US-A1- 2008 311 531
US-A1- 2017 261 847**

EP 4 003 634 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

TECHNISCHES GEBIET

Die hierin offenbarten Gegenstände betreffen das Gebiet der Laserbearbeitungsvorrichtungen und -verfahren, insbesondere Laserbearbeitungsvorrichtung entsprechend Ansprüche 1, 11 und 12, Verfahren zur Interferenzstrukturierung einer Oberfläche entsprechend Anspruch 9, Verwendung entsprechend Anspruch 10, und Objekte entsprechend Ansprüche 13 und 15.

HINTERGRUND

Eine Bearbeitung von Oberflächen und Bauteilen mittels Laserstrahlung hat vielfältige Anwendungen, beispielsweise die Strukturierung von Oberflächen. Beispielsweise offenbart die WO 2018/197555 A1 ein Verfahren und eine Vorrichtung zum Herstellen von Riblets (d.h. Rippen), wobei die Riblets mittels Laserinterferenzstrukturierung (DLIP - Direct Laser Interference Patterning) in eine Oberfläche, insbesondere in eine bereits lackierte und ausgehärtete Oberfläche, eingebracht werden. Ein Bauteil mit den auf diese Weise hergestellten Riblets ermöglicht es, Flugzeuge, Schiffe und Windkraftanlagen mit einem geringeren Strömungswiderstand zu betreiben.
JP 2006 110587 A offenbart ein Laserinterferenzprozessierverfahren und eine Vorrichtung zum Prozessieren oder Modifizieren eines Arbeitsmaterial unter Verwendung eines Ultrakurzpulslasers. Durch Verwenden von Licht nur in einem Zentralbereich einer Kohärenzregion ist es möglich, eine Ungleichförmigkeit der Prozessiertiefe zu reduzieren.
US 2008/311531A1 stellt ein Verfahren und eine Vorrichtung zur Erzeugung periodischer Muster durch schrittweise Interferenzlithographie zur Verfügung, indem die Substate oder die Lichtstrahlen schrittweise bewegt werden, um einen strukturierten Bereich mit einer großen Fläche auf dem Substrat zu bilden.
US 2017/261847 A1 offenbart die Anordnung einer Vielzahl von der Interferenzlicht-Bestrahlungsregionen in aufeinanderfolgenden Belichtungen, um nebeneinander auf dem Substrat in einer Transportrichtung des Substrats, ohne dass die störenden Lichtbestrahlungsregionen überlappt werden, wenn das Substrat belichtet wird, während es schrittweise transportiert wird.
DE 196 23 352 A1 betrifft ein Verfahren zur Herstellung von eine räumlich gemusterte Oberfläche aufweisenden Druck- oder Prägezylindern mittels eines lithographischen Verfahren und schlägt zur Vermeidung von Unschärfen vor, dass der auf die Zylinder-Oberfläche abgebildete oder projizierte Strahl synchron zu der Bewegung der Zylinder-Oberfläche bei der Drehung mitbewegt wird, wobei dies vorteilhafterweise dadurch erreicht wird, das das strahlformende Element zur Erzeugung der Bewegung des abgebildeten oder projizierten Strahles synchron zu der Bewegung der Zylinder-Oberfläche bewegt wird.

ZUSAMMENFASSUNG

Angesichts der oben beschriebenen Situation gibt es ein Bedürfnis für eine Technik, welche eine Strukturierung von Oberflächen mit verbesserten Charakteristika erlaubt.
Diesem Bedürfnis wird durch die Gegenstände der unabhängigen Ansprüche Rechnung getragen. Vorteilhafte Ausführungsformen sind in den abhängigen Ansprüchen angegeben.
Die beanspruchte Erfindung ist in den unabhängigen Ansprüchen 1, 9, 10, 11, 12, 13 und 15 definiert und basiert auf Ausführungsformen der hierin offenbarten Gegenstände.
Weitere besondere Ausführungsbeispiele sind in den abhängigen Ansprüchen definiert.
Gemäß einem ersten Aspekt der hierin offenbarten Gegenstände wird eine eine Laserbearbeitungsvorrichtung entsprechend Anspruch 1. Gemäß Ausführungsformen des ersten Aspektes wird eine
Laserbearbeitungsvorrichtung offenbart, die Laserbearbeitungsvorrichtung aufweisend: eine optische Anordnung; wobei die optische Anordnung einen Eingang aufweist zum Empfangen eines Laserstrahls; und wobei die optische Anordnung einen Strahlteiler aufweist, welcher den Laserstrahl in mindestens zwei Teilstrahlen teilt; und wobei die optische Anordnung die Teilstrahlen wieder zu einem Laserspot zusammenführt zur Erzeugung eines Interferenzmusters in dem Laserspot; wobei eine Änderung einer Position des Laserstahls an dem Eingang und/oder eine Änderung eines Einfallswinkels des Laserstrahls bezüglich des Eingangs mindestens eines von dem folgenden bewirkt: (i) eine Abstandsänderung DP eines Abstands zwischen einem Zentrum des Laserspots und einem in einer vorbestimmten Richtung nächstliegenden Interferenzmaximum des Interferenzmusters, (ii) eine Positionsänderung DS einer Position des Zentrums des Laserspots; wobei die optische Anordnung so konfiguriert ist, dass eine Bedingung

$$|DS| + |DP| = n*L \qquad \text{(Gleichung 1)}$$

für eine kontinuierliche Positionsänderung DS gilt, und wobei n eine natürliche Zahl ist; wobei L ein Abstand zwischen zwei benachbarten Interferenzmaxima des Interferenzmusters in der vorbestimmten Richtung ist, einschließlich eines Toleranzbereichs von $\pm$ 5 %; und wobei die Abstandsänderung DP definiert ist durch eine Differenz von einem ersten Abstand und einem zweiten Abstand; und wobei jeder von dem ersten Abstand und dem zweiten Abstand in der vorbestimmten Richtung definiert ist.

Gemäß einem zweiten Aspekt der hierin offenbarten Gegenstände wird ein Verfahren zur Interferenzstrukturierung einer Oberfläche, siehe Anspruch 9, offenbart.

Gemäß Ausführungsformen des zweiten Aspektes wird ein Verfahren zur Interferenzstrukturierung einer Oberfläche offenbart, das Verfahren aufweisend: Erzeugen eines ersten Interferenzmusters auf der Oberfläche; Erzeugen eines zweiten Interferenzmusters auf der Oberfläche; wobei das Erzeugen des ersten Interferenzmusters und des zweiten Interferenzmusters durch eine einzige optische Anordnung erfolgt, welche einen Eingang aufweist; wobei das erste Interferenzmuster und das zweite Interferenzmuster durch die optische Anordnung erzeugt werden, indem eine Position des Laserstahls an dem Eingang und/oder ein Einfallswinkels des Laserstrahls bezüglich des Eingangs verändert wird und hierdurch (i) eine Abstandsänderung DP eines Abstands zwischen einem Zentrum des Laserspots und einem in einer vorbestimmten Richtung nächstliegenden Interferenzmaximum des Interferenzmusters erfolgt, und/oder (ii) eine Positionsänderung DS einer Position des Zentrums des Laserspots erfolgt; wobei die optische Anordnung so konfiguriert ist, dass eine Bedingung

$$|DS| + |DP| = n*L \qquad \text{(Gleichung 1)}$$

für eine kontinuierliche Positionsänderung DS erfüllt ist; und wobei n eine natürliche Zahl ist; L ein Abstand zwischen zwei benachbarten Interferenzmaxima des ersten Interferenzmusters ist, einschließlich eines Toleranzbereichs von $\pm$ 5 %; und wobei die Abstandsänderung DP definiert ist durch eine Differenz von einem ersten Abstand und einem zweiten Abstand; und wobei jeder von dem ersten Abstand und dem zweiten Abstand in der vorbestimmten Richtung definiert ist.

Gemäß einer Ausführungsform eines dritten Aspektes wird eine Verwendung entsprechend Anspruch 10 offenbart.

Gemäß Ausführungsformen des dritten Aspektes wird offenbart: Eine Verwendung einer optischen Anordnung zur Erzeugung eines ersten Interferenzmusters und eines zweiten Interferenzmusters durch Änderung einer Position des Laserstahls an dem Eingang und/oder Änderung eines Einfallswinkels des Laserstrahls bezüglich des Eingangs und hierdurch

Bewirken von mindestens einem von: (i) einer Abstandsänderung DP eines Abstands zwischen einem Zentrum des Laserspots und einem in einer vorbestimmten Richtung nächstliegenden Interferenzmaximum des Interferenzmusters, (ii) einer Positionsänderung DS einer Position des Zentrums des Laserspots; wobei die optische Anordnung so konfiguriert ist, dass eine Bedingung

$$|DS| + |DP| = n*L \qquad \text{(Gleichung 1)}$$

für eine kontinuierliche Positionsänderung DS gilt; und wobei n eine natürliche Zahl ist; L ein Abstand zwischen zwei benachbarten Interferenzmaxima des Interferenzmusters ist, einschließlich eines Toleranzbereichs von $\pm$ 5 %; und wobei die Abstandsänderung DP definiert ist durch eine Differenz von einem ersten Abstand und einem zweiten Abstand; und wobei jeder von dem ersten Abstand und dem zweiten Abstand in der vorbestimmten Richtung definiert ist. Gemäß einem vierten Aspekt der hierin offenbarten Gegenstände wird eine Laserbearbeitungsvorrichtung offenbart.

Gemäß Ausführungsformen des vierten Aspektes wird eine Laserbearbeitungsvorrichtung entsprechend Anspruch 11 offenbart, die Laserbearbeitungsvorrichtung aufweisend: eine optische Anordnung; wobei die optische Anordnung einen Eingang aufweist zum Empfangen eines Laserstrahls; und wobei die optische Anordnung einen Strahlteiler aufweist, welcher den Laserstrahl in mindestens zwei Teilstrahlen teilt; und wobei die optische Anordnung die Teilstrahlen wieder zu einem Laserspot zusammenführt zur Erzeugung eines Interferenzmusters in dem Laserspot; wobei ein erster Zustand des Laserstrahls an dem Eingang ein erstes Interferenzmuster erzeugt und ein zweiter Zustand des Laserstrahls ein zweites Interferenzmuster erzeugt; wobei der erste Zustand und der zweite Zustand sich in mindestens einem von (i) einer Position des Laserstahls an dem Eingang und (ii) einem Einfallswinkel des Laserstrahls bezüglich des Eingangs unterscheiden; und wobei die optische Anordnung konfiguriert ist, so dass das zweite Interferenzmuster das erste Interferenzmuster in Phase fortsetzt.

Gemäß einem fünften Aspekt der hierin offenbarten Gegenstände wird Laserbearbeitungsvorrichtung entsprechend Anspruch 11 offenbart.

Gemäß Ausführungsformen des sechsten Aspektes wird eine Laserbearbeitungsvorrichtung offenbart aufweisend: eine optische Anordnung; wobei die optische Anordnung einen Eingang aufweist zum Empfangen eines Laserstrahls; wobei die optische Anordnung einen Strahlteiler aufweist, welcher den Laserstrahl in mindestens zwei Teilstrahlen teilt; wobei die optische Anordnung die Teilstrahlen wieder zu einem Laserspot zusammenführt zur Erzeugung eines Interferenzmusters in dem Laserspot; wobei ein erster Zustand des Laserstrahls an dem Eingang ein erstes Interferenzmuster erzeugt und ein zweiter Zustand des Laserstrahls ein zweites Interferenzmuster erzeugt; wobei der erste Zustand und der zweite Zustand sich in mindestens einem von (i) einer Position des Laserstahls an dem Eingang und (ii) einem Einfallswinkel des Laserstrahls bezüglich des Eingangs unterscheiden; wobei ein Zentrum des ersten Interferenzmusters und ein Zentrum des zweiten Interferenzmusters einen Abstand aufweisen, der mindestens dem einfachen Durchmesser des Laserspots entspricht, insbesondere mindestens dem fünffachen Durchmesser des Laserspots, ferner insbesondere mindestens dem zehnfachen Durchmesser des Laserspots, ferner insbesondere mindestens dem zwanzigfachen Durchmesser des Laserspots; wobei eine Änderung einer Weglänge eines Strahlungsweges von jedem der Teilstrahlen aufgrund der Zustandsänderung von dem ersten Zustand zu dem zweiten Zustand kleiner als $\pm$ 5% der gesamten Weglänge des Strahlungsweges von dem Strahlteiler bis zu dem Laserspot ist, insbesondere kleiner als $\pm$ 1% und ferner insbesondere kleiner als $\pm$ 0,5% ist.

Gemäß einem sechsten Aspekt der hierin offenbarten Gegenstände wird ein Objekt entsprechend Anspruch 13 offenbart.

Gemäß Ausführungsformen des sechsten Aspektes wird ein Objekt offenbart mit einer Oberfläche, welche eine periodische Oberflächenstruktur aufweist, wobei die Oberflächenstruktur durch eine Umfangslinie begrenzt ist und wobei die Umfangslinie mindestens abschnittsweise in einem Umfangslinienabschnitt eine Form aufweist, die eine periodische Wiederholung eines Grundelementes ist, und wobei sich eine Periodizität der Oberflächenstruktur von einer Periodizität des Umfangslinienabschnitts abweicht.

Gemäß einem siebten Aspekt der hierin offenbarten Gegenstände wird ein Objekt entsprechend Anspruch 15 offenbart.

Gemäß Ausführungsformen des siebten Aspektes wird ein Objekt offenbart mit einer Oberfläche, wobei die Oberfläche eine Oberflächenstruktur aufweist; wobei die Oberflächenstruktur die eine maximale Tiefenerstreckung bezüglich der Oberfläche hat; eine Tiefenerstreckung der Oberflächenstruktur von einer ersten Position an einem Rand der Oberflächenstruktur bis zu einer zweiten Position auf 80 % der maximalen Tiefenerstreckung zunimmt; und ein Abstand zwischen der ersten Position und der zweiten Position mindestens 100 $\mu$m beträgt.

Verschiedene Aspekte und Ausführungsformen der hierin offenbarten Gegenstände basieren auf der Idee, dass ein Interferenzmuster eines Laserspots über den Laserspot hinaus in Phase fortzusetzen. Dies kann beispielsweise über eine geeignete Regelung der Phase, zum Beispiel durch Liefern einer geeigneten Differenz DI_AB zwischen der optischen Weglängendifferenz des ersten Zustands und der optischen Weglängendifferenz des zweiten Zustands erfolgen. Darüber hinaus haben die Erfinder festgestellt, dass entgegen der Auffassung der betreffenden Fachkreise zumindest für bestimmte optische Anordnungen eine "automatische", lediglich durch den Aufbau der optischen Anordnung bedingte phasengetreue Fortsetzung eines Interferenzmusters über die räumliche Ausdehnung eines Laserspots hinaus möglich ist. Jedenfalls in Anwendungen, in denen eine großflächige Bearbeitung mit periodischen Mustern vorteilhaft ist, kann durch die phasengetreue Fortsetzung eine Laserbearbeitungsvorrichtung äußerst effizient konfiguriert werden.

Gemäß Ausführungsformen des ersten Aspektes ist die Laserbearbeitungsvorrichtung ausgebildet zum Liefern der Funktionalität von einer oder mehreren der hierin offenbarten Ausführungsformen und/oder zum Liefern der Funktionalität, wie sie für eine oder mehrere der hierin offenbarten Ausführungsformen erforderlich ist, insbesondere der Ausführungsformen des ersten, zweiten, dritten, vierten, fünften, sechsten, und/oder siebten Aspektes.

Gemäß Ausführungsformen des zweiten Aspektes ist das Verfahren ausgebildet zum Liefern der Funktionalität von einer oder mehreren der hierin offenbarten Ausführungsformen und/oder zum Liefern der Funktionalität, wie sie für eine oder mehrere der hierin offenbarten Ausführungsformen erforderlich ist, insbesondere der Ausführungsformen des ersten, zweiten, dritten, vierten, fünften, sechsten, und/oder siebten Aspektes.

Gemäß Ausführungsformen des dritten Aspektes ist die Verwendung ausgebildet zum Liefern der Funktionalität von einer oder mehreren der hierin offenbarten Ausführungsformen und/oder zum Liefern der Funktionalität, wie sie für eine oder mehrere der hierin offenbarten Ausführungsformen erforderlich ist, insbesondere der Ausführungsformen des ersten, zweiten, dritten, vierten, fünften, sechsten, und/oder siebten Aspektes.

Gemäß Ausführungsformen des vierten Aspektes ist die Laserbearbeitungsvorrichtung ausgebildet zum Liefern der Funktionalität von einer oder mehreren der hierin offenbarten Ausführungsformen und/oder zum Liefern der Funktionalität, wie sie für eine oder mehrere der hierin offenbarten Ausführungsformen erforderlich ist, insbesondere der Ausführungsformen des ersten, zweiten, dritten, vierten, fünften, sechsten, und/oder siebten Aspektes.

Gemäß Ausführungsformen des fünften Aspektes ist das Verfahren ausgebildet zum Liefern der Funktionalität von einer oder mehreren der hierin offenbarten Ausführungsformen und/oder zum Liefern der Funktionalität, wie sie für eine oder mehrere der hierin offenbarten Ausführungsformen erforderlich ist, insbesondere der Ausführungsformen des ersten, zweiten, dritten, vierten, fünften, sechsten, und/oder siebten Aspektes.

Gemäß Ausführungsformen des sechsten Aspektes ist das Objekt ausgebildet zum Liefern der Funktionalität von einer oder mehreren der hierin offenbarten Ausführungsformen und/oder zum Liefern der Funktionalität, wie sie für eine oder mehrere der hierin offenbarten Ausführungsformen erforderlich ist, insbesondere der Ausführungsformen des ersten, zweiten, dritten, vierten, fünften, sechsten, und/oder siebten Aspektes.

Gemäß Ausführungsformen des siebten Aspektes ist das Objekt ausgebildet zum Liefern der Funktionalität von einer oder mehreren der hierin offenbarten Ausführungsformen und/oder zum Liefern der Funktionalität, wie sie für eine oder mehrere der hierin offenbarten Ausführungsformen erforderlich ist, insbesondere der Ausführungsformen des ersten, zweiten, dritten, vierten, fünften, sechsten, und/oder siebten Aspektes.

Weitere Vorteile und Merkmale der hierin offenbarten Gegenstände ergeben sich aus der folgenden beispielhaften Beschreibung derzeit bevorzugter Ausführungsformen, auf welche die vorliegende Offenbarung jedoch nicht beschränkt ist. Die einzelnen Figuren der Zeichnungen dieser Anmeldung sind lediglich als schematisch und als nicht notwendigerweise maßstabsgetreu anzusehen.

KURZE BESCHREIBUNG DER ZEICHNUNGEN

Fig. 1 zeigt schematisch ein Funktionsprinzip einer optischen Anordnung gemäß Ausführungsformen der hierin offenbarten Gegenstände.

Fig. 2 zeigt eine Laserbearbeitungsvorrichtung gemäß Ausführungsformen der hierin offenbarten Gegenstände.

Fig. 3 zeigt einen Teil einer Laserbearbeitungsvorrichtung gemäß Ausführungsformen der hierin offenbarten Gegenstände.

Fig. 4 zeigt einen Teil einer Laserbearbeitungsvorrichtung gemäß Ausführungsformen der hierin offenbarten Gegenstände.

Fig. 5 zeigt ein erstes Interferenzmuster und ein zweites Interferenzmuster, wie sie von einer Laserbearbeitungsvorrichtung gemäß Ausführungsformen der hierin offenbarten Gegenstände erzeugt werden können.

Fig. 6 zeigt in einer Schnittdarstellung einen Teil einer optischen Anordnung einer Laserbearbeitungsvorrichtung gemäß Ausführungsformen der hierin offenbarten Gegenstände.

Fig. 7 zeigt einen Teil eines Objektes gemäß Ausführungsformen der hierin offenbarten Gegenstände.

Fig. 8 zeigt einen Teil eines Objektes gemäß Ausführungsformen der hierin offenbarten Gegenstände.

Fig. 9 zeigt einen Teil eines Objektes gemäß Ausführungsformen der hierin offenbarten Gegenstände.

Fig. 10 zeigt eine Querschnittsansicht eines Teils der Oberflächenstruktur aus Fig. 9 entlang der Schnittlinie X-X in Fig. 9.

Fig. 11 zeigt eine Aufsicht auf einen Teil einer Oberflächenstruktur gemäß Ausführungsformen der hierin offenbarten Gegenstände.

Fig. 12 und 13 zeigen eine Querschnittsansicht der Oberflächenstruktur aus Fig. 11 entlang der Schnittlinien XII-XII bzw. XIII-XIII in Fig. 11.

Fig. 14 zeigt eine Laserbearbeitungsvorrichtung gemäß Ausführungsformen der hierin offenbarten Gegenstände.

BESCHREIBUNG EXEMPLARISCHER AUSFÜHRUNGSFORMEN

Im Folgenden werden exemplarische Ausführungsformen der hierin offenbarten Gegenstände beschrieben, wobei beispielsweise auf eine Laserbearbeitungsvorrichtung, ein Verfahren, eine Verwendung und ein Objekt Bezug genommen wird. Es sollte hervorgehoben werden, dass natürlich jede Kombination von Merkmalen verschiedener Aspekte, Ausführungsformen und Beispiele möglich ist. Insbesondere werden einige Ausführungsformen mit Bezug auf ein Verfahren oder eine Verwendung beschrieben, während andere Ausführungsformen mit Bezug auf eine Vorrichtung, insbesondere eine Laserbearbeitungsvorrichtung oder ein Objekt beschrieben werden. Jedoch wird der Fachmann der vorstehenden und der nachfolgenden Beschreibung, den Ansprüchen und den Zeichnungen entnehmen, dass, solange es nicht anders angegeben ist, Merkmale verschiedener Aspekte, Ausführungsformen und Beispiele kombinierbar sind und solche Kombinationen von Merkmalen als durch diese Anmeldung offenbart anzusehen sind. Beispielsweise ist selbst ein Merkmal, welches sich auf ein Verfahren oder eine Verwendung bezieht, mit einem Merkmal kombinierbar, welches sich auf eine Vorrichtung (beispielsweise eine Laserbearbeitungsvorrichtung oder ein Objekt), bezieht, und umgekehrt. Ferner ist ein Merkmal einer Ausführungsform, welches sich auf eine Vorrichtung bezieht, mit einem korrespondierenden Merkmal kombinierbar, welches sich auf ein Verfahren oder eine Verwendung bezieht. Mit der Offenbarung eines Verfahrens, einer Ausführungsform eines Verfahrens oder einer Funktion sind ferner ein oder mehrere Aktoren sowie eine mit den Aktoren zusammenwirkende Funktionalität einer Steuervorrichtung als offenbart anzusehen, welche zur Ausführung des Verfahrens bzw. der Funktion ausgebildet sind. Ferner ist mit der Offenbarung einer Funktion einer Vorrichtung ein entsprechendes Verfahren, welches die Funktion ohne Vorrichtungsmerkmale definiert, als offenbart anzusehen. Ferner definieren Merkmale eines Interferenzmusters analoge Merkmale einer Oberflächenstruktur oder eines Bearbeitungsspots (Oberflächenbereich, der durch einen Laserspot, der das Interferenzmuster aufweist, bearbeitet wird).

Ein Verfahren kann implementiert sein als computerlesbarer Instruktionscode durch Verwendung von irgendeiner geeigneten Programmiersprache, wie beispielsweise, zum Beispiel, JAVA, C#, etc. und kann gespeichert sein auf einem computerlesbaren Medium (entfernbare Disc, flüchtiger oder nichtflüchtiger Speicher, Embedded Speicher/-Prozessor etc.). Der Instruktionscode ist betreibbar zum Programmieren eines Computers oder irgendeiner anderen programmierbaren Prozessorvorrichtung zum Ausführen der beabsichtigten Funktionen. Der Instruktionscode kann von einem Netzwerk verfügbar sein, beispielsweise von dem WorldWideWeb, von welchem es heruntergeladen werden kann.

Die hierin offenbarten Gegenstände können realisiert werden mittels eines Programmelements bzw. Software. Jedoch können die hierin offenbarten Gegenstände auch realisiert werden mittels einem oder mehreren spezifischen elektronischen Schaltungen bzw. Hardware. Ferner können die hierin offenbarten Gegenstände auch in Hybridform realisiert werden, d.h. in einer Kombination von Softwaremodulen und Hardwaremodulen.

Sofern nichts anderes angegeben ist, sind Zahlenwerte einschließlich eines $\pm 5$ %-Fensters zu verstehen, d. h. beispielsweise eine Angabe einer Länge von 10 mm umfasst gemäß einer Ausführungsform eine Länge innerhalb eines Intervalls von (10 mm $\pm$ 5 %) = [9,95 mm; 10,05 mm] und eine Prozentangabe von 50 % umfasst gemäß einer Ausführungsform eine Prozentangabe innerhalb eines Intervalls von 50 % $\pm$ 5 % = [47,5 %; 52,5 %]. Gemäß einer weiteren Ausführungsform sind Zahlenwerte einschließlich eines $\pm 10$ %-Fensters zu verstehen.

Gemäß einer Ausführungsform wird eine Vorrichtung offenbart. Gemäß einer weiteren Ausführungsform ist die Vorrichtung eine Laserbearbeitungsvorrichtung. Gemäß einer weiteren Ausführungsform weist die Vorrichtung eine optische Anordnung auf, wobei die optische Anordnung einen Eingang aufweist zum Empfangen eines Laserstrahles. Gemäß einer weiteren Ausführungsform weist die optische Anordnung einen Strahlteiler auf, welcher den Laserstrahl in zwei oder mehr Teilstrahlen teilt, wobei die optische Anordnung die Teilstrahlen wieder zu einem Laserspot zusammenführt zur Erzeugung eines Interferenzmusters in dem Laserspot. Gemäß einer weiteren Ausführungsform bewirkt eine Änderung einer Position des Laserstrahles an dem Eingang und/oder eine Änderung eines Einfallswinkels des Laserstrahles bezüglich des Eingangs mindestens eines von dem folgenden: (i) eine Abstandsänderung DP eines Abstands zwischen einem Zentrum des Laserspots und einem in einer vorbestimmten Richtung nächstliegenden Interferenzmaximum des Interferenzmusters, (ii) eine Positionsänderung DS einer Position des Zentrums des Laserspots. Gemäß einer Ausführungsform ist die optische Anordnung so konfiguriert, dass die Bedingung in der nachfolgenden Gleichung 1

$$|DS| + |DP| = n*L \qquad\qquad (Gleichung\ 1)$$

für eine kontinuierliche Positionsänderung DS gilt, und wobei n eine natürliche Zahl ist. L ist hierbei ein Abstand zwischen zwei benachbarten Interferenzmaxima des Interferenzmusters in der vorbestimmten Richtung, einschließlich eines Toleranzbereichs von $\pm$ 5 %. Mit anderen Worten muss die Bedingung gemäß einer Ausführungsform nicht exakt erfüllt sein, sondern Abweichungen in der Größenordnung von $\pm$ 5 % von dem exakten Wert n*L sind ebenfalls tolerierbar, d.h. die Bedingung gilt auch für Abweichungen, die innerhalb des Toleranzbereichs liegen, als erfüllt. Allgemein ist gemäß einer weiteren Ausführungsform der Toleranzbereich $\pm$ 3 % oder, gemäß nochmals anderer Ausführungsform $\pm$ 1 %. Gemäß nochmals anderer Ausführungsform ist Gleichung 1 exakt erfüllt (Toleranzbereich 0 %). Ferner ist die Abstandsänderung DP definiert durch eine Differenz von einem ersten Abstand und einem zweiten Abstand, wobei jeder von dem ersten Abstand und dem zweiten Abstand in der vorbestimmten Richtung definiert ist. Der erste Abstand und der zweite Abstand geben demnach den Abstand zwischen dem Zentrum des betreffenden Laserspots und dem in der vorbestimmten Richtung nächstliegenden Interferenzmaximum des Interferenzmusters des betreffenden Laserspots an. $||$ ist hier die bekannte Betragsfunktion, d.h. $|x| = x$ für $x \geq 0$ und $|x| = - x$ für $x < 0$.

Entsprechend weist gemäß einer Ausführungsform ein Verfahren eine oder mehrere der folgenden Ausführungsformen auf. Gemäß einer Ausführungsform weist ein Verfahren zur Interferenzstrukturierung einer Oberfläche eines oder mehrere der folgenden Merkmale auf: Erzeugen eines ersten Interferenzmusters auf der Oberfläche; Erzeugen eines zweiten Interferenzmusters auf der Oberfläche; wobei das Erzeugen des ersten Interferenzmusters und des zweiten Interferenzmusters durch eine einzige optische Anordnung erfolgt, welche einen Eingang aufweist. Gemäß einer Ausführungsform werden das erste Interferenzmuster und das zweite Interferenzmuster durch die optische Anordnung erzeugt, indem eine Position des Laserstrahles an dem Eingang und/oder ein Einfallswinkel des Laserstrahles bezüglich des Eingangs verändert wird und hierdurch (i) eine Abstandsänderung DP eines Abstands zwischen einem Zentrum des Laserspots und einem in einer vorbestimmten Richtung nächstliegenden Interferenzmaximum des Interferenzmusters erfolgt, und/oder (ii) eine Positionsänderung DS einer Position des Zentrums des Laserspots erfolgt.

Gemäß einer weiteren Ausführungsform weist ein Verfahren eines oder mehrere der folgenden Merkmale auf: Bereitstellen einer optischen Anordnung mit einem Strahlteiler, welcher einen Laserstrahl in mindestens zwei Teilstrahlen teilt wobei die optische Anordnung die Teilstrahlen wieder zu einem Laserspot zusammenführt; Richten eines Laserstrahles auf einen Eingang der optischen Anordnung; wobei ein erster Zustand des Laserstrahls an dem Eingang den Laserspot an einer ersten Position P1 erzeugt, wobei der Laserspot ein erstes Interferenzmuster aufweist; wobei ein zweiter Zustand des Laserstrahls an dem Eingang den Laserspot an einer zweiten Position P2 erzeugt, wobei der Laserspot ein zweites Interferenzmuster aufweist; wobei der erste Zustand und der zweite Zustand sich in mindestens einem von (i) einer Position des Laserstahls an dem Eingang und (ii) einem Einfallswinkel des Laserstrahls bezüglich des Eingangs unterscheiden; und wobei die optische Anordnung (oder, gemäß anderer Ausführungsform, das Verfahren) für die Positionsänderung DS = P1 - P2 eine Differenz DI_AB = DI_A - DI_B zwischen einer ersten optischen Weglängendifferenz DI_A und einer zweiten optischen Weglängendifferenz DI_B liefert, welche eine Abstandsänderung DP zwischen einem Zentrum des Laserspots und einem in einer vorbestimmten Richtung nächstliegenden Interferenzmaximum des Interferenzmusters bewirkt, so dass das zweite Interferenzmuster das erste Interferenzmuster in Phase fortsetzt.

Die optische Anordnung ist gemäß einer Ausführungsform so konfiguriert, dass die Bedingung gemäß Gleichung 1 für eine kontinuierliche Positionsänderung DS erfüllt ist.

Die Position des Laserstrahles an dem Eingang und/oder die Änderung des Einfallswinkels des Laserstrahles bezüglich des Eingangs kann allgemeiner auch als Zustand des Laserstrahles an dem Eingang beschrieben werden. Gemäß einer Ausführungsform ist der Eingang der optischen Anordnung durch den Strahlteiler gebildet. Dies schließt selbstverständlich nicht aus, dass vor dem Strahlteiler optische Elemente angeordnet sind, die dann in diesem Sinne allerdings nicht zu der optischen Anordnung gehören.

In diesem Sinne erzeugt gemäß einer Ausführungsform ein erster Zustand des Laserstrahles an dem Eingang ein erstes Interferenzmuster in dem Laserspot (in einem ersten Laserspot, wobei der erste Laserspot sein Zentrum an einer ersten Position P1 hat) und ein zweiter Zustand des Laserstrahles an dem Eingang erzeugt ein zweites Interferenzmuster in dem Laserspot (in einem zweiten Laserspot, wobei der zweite Laserspot sein Zentrum an einer zweiten Position P2 hat), wobei sich der erste Zustand und der zweite Zustand in mindestens einem von (i) einer Position des Laserstrahles an dem Eingang und (i) einem Einfallswinkel des Laserstrahles bezüglich des Eingangs unterscheiden.

Entsprechend den vorstehenden Ausführungen weist gemäß einer Ausführungsform eine Verwendung einer optischen Anordnung zur Erzeugung eines ersten Interferenzmusters und eines zweiten Interferenzmusters durch Änderung einer Position des Laserstrahles an dem Eingang und/oder Änderung eines Einfallswinkels des Laserstrahles bezüglich des Eingangs und hierdurch Bewirken von mindestens einem von: (i) einer Abstandsänderung DP eines Abstands zwischen einem Zentrum des Laserspots und einem in einer vorbestimmten Richtung nächstliegenden Interferenzmaximum des Interferenzmusters, (ii) einer Positionsänderung DS einer Position des Zentrums des Laserspots, auf, wobei die optische Anordnung so konfiguriert ist, dass die Bedingung gemäß Gleichung 1 erfüllt ist.

Gemäß einer nochmals weiteren Ausführungsform weist eine Laserbearbeitungsvorrichtung eines oder mehrere der folgenden Merkmale auf: eine optische Anordnung; wobei die optische Anordnung einen Eingang aufweist zum Empfangen eines Laserstrahles; und wobei die optische Anordnung einen Strahlteiler aufweist, welcher den Laserstrahl in mindestens zwei Teilstrahlen teilt; und wobei die optische Anordnung die Teilstrahlen wieder zu einem Laserspot zusammenführt zur Erzeugung eines Interferenzmusters in dem Laserspot; wobei ein erster Zustand des Laserstrahles an dem Eingang ein erstes Interferenzmuster erzeugt und ein zweiter Zustand des Laserstrahles an dem Eingang ein zweites Interferenzmuster erzeugt; und wobei der erste Zustand und der zweite Zustand sich in mindestens einem von (i) einer Position des Laserstrahles an dem Eingang und (ii) einem Einfallswinkel des Laserstrahles bezüglich des Eingangs unterscheiden; und wobei die optische Anordnung konfiguriert ist, so dass das zweite Interferenzmuster das erste Interferenzmuster in Phase fortsetzt.

Die Änderung des Zustands des Laserstrahles an dem Eingang und insbesondere die Änderung der Position des Laserstrahles an dem Eingang und/oder die Änderung des Einfallswinkels des Laserstrahles bezüglich des Eingangs schließt nicht aus, dass auch die optische Anordnung und die Oberfläche relativ zueinander bewegt werden, um größere Oberflächenbereiche zu strukturieren. Beispielsweise kann bei einer 2-Strahl-Interferenz (die zu einem Interferenzmuster führt, welches eine Vielzahl von parallelen Linien aufweist) die optische Anordnung in einer Richtung der Längserstreckung der Linien bewegt werden, um eine großflächige Oberflächenstrukturierung zu erzielen, wie dies beispielsweise bei einer Anwendung wünschenswert ist, in welcher die durch das Interferenzmuster erzeugte Oberflächenstruktur sogenannte Riblets auf einem Strömungselement, beispielsweise einem Flugzeugteil, bildet.

Gemäß einer Ausführungsform ist die optische Anordnung konfiguriert, so dass das zweite Interferenzmuster das erste Interferenzmuster in Phase fortsetzt.

Beispielsweise kann gemäß einer Ausführungsform die entsprechende Konfiguration der optischen Anordnung aktiv sein, beispielsweise indem die Abstandsänderung DP durch eine geeignete Aktoranordnung, die beispielsweise auf eine Spiegelanordnung oder ein optisches Medium einwirkt, eingestellt wird. Beispielsweise könnte hierfür ein keilförmiges optisches Element eingesetzt werden, welches weiter in einen der Teilstrahlen hinein oder aus diesem herausgefahren wird, wodurch die Weglänge des Teilstrahls innerhalb des keilförmigen optischen Elementes vergrößert oder verkleinert und damit die Phasenlage (und damit DP) geändert werden kann. Die Steuersignale für die Aktoranordnung können beispielsweise aus der Ermittlung des Zustands des Laserstrahles mithilfe einer Nachschlagetabelle oder beispielsweise auch durch eine geeignet trainierte künstliche Intelligenz erzeugt werden.

Ferner kann gemäß einer Ausführungsform die Konfiguration der optischen Anordnung zur in-Phase-Fortsetzung des ersten Interferenzmusters eine passive Konfiguration aufweisen, beispielsweise wenn einzelnen Elemente der optischen Anordnung wie auch das Zusammenwirken der einzelnen optischen Elemente derart konfiguriert ist, dass das phasengetreue Fortsetzen des ersten Interferenzmusters allein aufgrund des (statischen) Aufbaus der optischen Anordnung erfolgt, jedenfalls innerhalb eines gewissen Gültigkeitsbereichs, beispielsweise eines Gültigkeitsbereichs für den Zustand des Laserstrahles (beispielsweise innerhalb eines gewissen Gültigkeitsbereichs für die Position des Laserstrahles an dem Eingang und/oder dem Einfallswinkel des Laserstrahles bezüglich des Eingangs) oder eines Gültigkeitsbereichs für die Positionsänderung DS. Allgemein ist gemäß einer Ausführungsform die Gleichung 1 mindestens innerhalb eines Gültigkeitsbereichs erfüllt.

Gemäß einer Ausführungsform definiert der erste Zustand des Laserstrahles an dem Eingang die erste Position P1 des Zentrums des Laserspots und das erste Interferenzmuster, und der zweite Zustand des Laserstrahles an dem Eingang definiert eine zweite Position P2 des Zentrums des Laserspots und ein zweites Interferenzmuster, wobei ein Paar von Teilstrahlen der mindestens zwei Teilstrahlen in dem ersten Zustand eine erste optische Weglängendifferenz DI_A aufweist und das Paar von Teilstrahlen in dem zweiten Zustand eine zweite optische Weglängendifferenz DI_B aufweist; und wobei die optische Anordnung für die entsprechende Positionsänderung DS = P1-P2 eine Differenz DI_AB = DI_A - DI_B zwischen der ersten optischen Weglängendifferenz DI_A und der zweiten optischen Weglängendifferenz DI_B liefert, welche eine Abstandsänderung DP bewirkt, so dass das zweite Interferenzmuster das erste Interferenzmuster in Phase fortsetzt.

Gemäß einer Ausführungsform ist die vorbestimmte Richtung, in welcher sowohl der erste Abstand als auch der zweite Abstand definiert sind, eine Richtung, welche von dem Zentrum des Laserspots weg und hin zu dem in dieser Richtung nächstliegenden Interferenzmaximum (beispielsweise des ersten Interferenzmusters, d.h. gemäß einer Ausführungsform definiert das erste Interferenzmuster die vorbestimmte Richtung) weist. Sofern beispielsweise das Interferenzmuster eine Vielzahl von parallelen Interferenzlinien aufweist (wie sich dies beispielsweise durch eine Zweistrahl-Interferenz ergibt), ist gemäß einer Ausführungsform die vorbestimmte Richtung eine Richtung senkrecht zu den Interferenzlinien. Beispielsweise kann in diesem Fall die vorbestimmte Richtung als eine Richtung senkrecht zu den Interferenzlinien und von dem Zentrum des Laserspots nach rechts weisend definiert sein.

Wie den Fachleuten bekannt ist, ist bei einer Interferenz von drei oder mehr Teilstrahlen, beispielsweise bei drei Teilstrahlen (Dreistrahlinterferenz), das Interferenzmuster beispielsweise ein Punktmuster. Gemäß einer Ausführungsform existieren zwei voneinander linear unabhängige vorbestimmte Richtungen, entlang welchen das Interferenzmuster in Phase fortsetzbar ist, was insbesondere bei der Dreistrahlinterferenz vorteilhaft ist.

Es versteht sich, dass, obwohl in einigen Ausführungsformen nur auf einzelne verschiedene Abstände, beispielsweise einen ersten Abstand und einen zweiten Abstand Bezug genommen wird, die betreffenden Ausführungsformen für alle Abstände gelten, solange die angegebene Bedingung in Gleichung 1 erfüllt ist.

Gemäß einer Ausführungsform ist die in Gleichung 1 angegebene Bedingung in einem vorbestimmten Gültigkeitsbereich (beispielsweise einem durch die optische Anordnung definierten Gültigkeitsbereich) gültig. Gemäß einer Ausführungsform gilt die Bedingung in Gleichung 1 mindestens bis zu einem Positionsänderungswert, der gleich dem Durchmesser des Laserspots ist. Gemäß einer weiteren Ausführungsform gilt die Bedingung in Gleichung 1 für eine kontinuierliche Positionsänderung DS von einer Ausgangsposition (Positionsänderung gleich null) bis zu dem Positionsänderungswert. Gemäß einer weiteren Ausführungsform ist der Positionsänderungswert gleich dem zweifachen oder, gemäß nochmals anderer Ausführungsformen, dem fünffachen, zehnfachen oder zwanzigfachen Durchmesser des Laserspots.

Gemäß einer Ausführungsform weist der Eingang einen ersten Bereich und einen zweiten Bereich auf und die Laserbearbeitungsvorrichtung weist eine Aktoranordnung zum Positionieren des Laserstrahles in dem ersten Bereich und anschließend in dem zweiten Bereich auf.

Beispielsweise ist gemäß einer Ausführungsform die Aktoranordnung eine Aktoranordnung eines Laserscanners, mittels welchem der Laserstrahl über den Eingang und insbesondere den ersten Bereich und den zweiten Bereich des Eingangs scanbar ist. Auf diese Weise ist eine kontinuierliche und phasengetreue Fortsetzung des Interferenzmusters eines Laserspots möglich.

Im Sinne der vorstehend genannten Ausführungsformen kann beispielsweise der erste Zustand dem auf den ersten Bereich einfallenden Laserstrahl entsprechen und der zweite Zustand kann dem auf den zweiten Bereich einfallenden Laserstrahl entsprechen.

Gemäß einer Ausführungsform überlappen das erste Interferenzmuster und das zweite Interferenzmuster. Beispielsweise weisen gemäß einer Ausführungsform das erste Interferenzmuster und das zweite Interferenzmuster eine Mehrzahl von Intensitätsmaxima und Intensitätsminima auf, die in einer Längsrichtung aufeinanderfolgend angeordnet sind. Gemäß einer Ausführungsform ist das zweite Interferenzmuster bezüglich des ersten Interferenzmusters in der Längsrichtung (oder parallel zu der Längsrichtung) versetzt. Ferner entspricht gemäß einer Ausführungsform die Längsrichtung der vorbestimmten Richtung.

Falls es mindestens zwei linearunabhängige Längsrichtungen gibt (beispielsweise, gemäß einer Ausführungsform, bei einer 3-Strahl-Interferenz), ist die vorbestimmte Richtung, in welcher der erste Abstand und der zweite Abstand definiert sind, parallel zu mindestens einer der Längsrichtungen.

Gemäß einer Ausführungsform weist die optische Anordnung mindestens ein optisches Element auf, welches in Transmission arbeitet (mit anderen Worten ist dieses mindestens eine optische Element ein transmittierendes optisches Element). Gemäß einer Ausführungsform ist eine Änderung eines Weglängenabschnitts eines Strahlungsweges von jedem der Teilstrahlen in dem transmittierenden optischen Element (d. h. von jedem der Teilstrahlen, dessen Strahlungsweg durch das transmittierende optische Element verläuft) kleiner $\pm$ 5%, insbesondere kleiner als $\pm$ 1% und ferner insbesondere kleiner als $\pm$ 0,5%, wobei die Änderung des Weglängenabschnitts durch eine Zustandsänderung des Laserstrahls an dem Eingang hervorgerufen ist. Gemäß einer Ausführungsform (d. h. optional aber nicht notwendigerweise) gehen alle Teilstrahlen der mindestens zwei Teilstrahlen (die der Strahlteiler aus dem Laserstrahl erzeugt) durch das transmittierende optische Element.

Gemäß einer Ausführungsform gelten die vorstehenden Ausführungsformen hinsichtlich des transmittierenden optischen Elements für jedes transmittierende optische Element der optischen Anordnung.

Gemäß einer Ausführungsform schließt von jedem transmittierenden optischen Element der optischen Anordnung nach dem Strahlteiler jedes durchstrahlte Flächenpaar, welches sich in einem Strahlungsweg von mindestens einem der Teilstahlen befindet, einen Winkel von höchstens 10 Grad ein, insbesondere einen Winkel von höchstens 5 Grad. In Experimenten wurde gefunden, dass ein kleinerer Winkel die in-Phase-Fortsetzung des Interferenzmusters fördern kann.

Gemäß einer Ausführungsform definiert die optische Anordnung für mindestens einen Teilstrahl der mindestens zwei Teilstrahlen einen Strahlungsweg, für den gilt: Der Strahlungsweg definiert für eine erste Position des Laserspots eine erste Wegdifferenz zwischen einer optischen Weglänge des Strahlungswegs und einer geometrischen Weglänge des Strahlungswegs; der Strahlungsweg definiert für eine zweite Position des Laserspots eine zweite Wegdifferenz zwischen einer optischen Weglänge des Strahlungswegs und einer geometrischen Weglänge des Strahlungswegs; und in einem Gültigkeitsbereich der Bedingung gilt mindestens eines von dem Folgenden: (i) eine Abweichung zwischen der ersten Wegdifferenz und der zweiten Wegdifferenz so klein, dass die Bedingung erfüllt ist; (ii) eine Abweichung zwischen der ersten Wegdifferenz und der zweiten Wegdifferenz beträgt weniger als das Zwanzigfache, insbesondere weniger als das Zehnfache, der Wellenlänge des Laserstrahls; (iii) sowohl die ersten Wegdifferenz als auch die zweite Wegdifferenz ist kleiner als 10 mm, insbesondere kleiner als 5 mm.

Gemäß einer Ausführungsform weist die optische Anordnung nach dem Strahlteiler kein Prisma auf.

Ohne die Betrachtung auf eine Theorie beschränken zu wollen, wirkt sich nach dem derzeitigen Verständnis der Erfinder eine starke Abweichung einer Weglängendifferenz zwischen einer optischen Weglänge eines Strahlungsweges und einer geometrischen Weglänge einer Strahlungsweges bei einer Änderung des Zustands des Laserstrahles bzw. einer Änderung der Position des Laserspots nachteilig auf den Gültigkeitsbereich aus oder verhindert sogar eine in-Phase-Fortsetzung des Interferenzmusters eines Laserspots.

Ausreichend klein in dem obigen Sinne ist gemäß einer Ausführungsform eine Abweichung zwischen der ersten Weglängendifferenz und der zweiten Weglängendifferenz dann, wenn die Abweichung kleiner als 10 % der Wellenlänge des Laserstrahles ist oder die Abweichung eine Verschiebung des Interferenzmusters aus der idealen Phase heraus von weniger als 5 % des Abstandes L zweier benachbarter Interferenzmaxima in der vorbestimmten Richtung bewirkt.

Gemäß einer Ausführungsform arbeiten alle optischen Elemente der optischen Anordnung in Reflexion, insbesondere arbeiten gemäß einer Ausführungsform alle optischen Elemente der optischen Anordnung ausschließlich in Reflexion. Mit anderen Worten sind alle optischen Elemente der optischen Anordnung reflektierende Elemente, gemäß einer weiteren Ausführungsform mit Ausnahme des Strahlteilers.

Der Begriff "in Reflexion arbeiten" hat in dieser Anmeldung gemäß einer Ausführungsform die Bedeutung, dass das betreffende optische Element eine optische Funktion aufweist, die auf Reflexion von einfallenden elektromagnetischer Strahlung beruht und mit dieser optischen Funktion zu der Gesamtfunktion der optischen Anordnung beiträgt. In diesem Sinne arbeitet auch ein halbdurchlässiger Spiegel in Reflexion.

Gemäß einer Ausführungsform ist der Strahlteiler ein halbdurchlässiger Spiegel. Gemäß einer Ausführungsform ist ein halbdurchlässiger Spiegel ein optisch transmittierendes Medium mit planen Oberflächen, wobei auf einer der planen Oberflächen (auf einer Eingangsseite) mindestens eine Schicht, insbesondere ein dielektrischer Schichtstapel aufgetragen ist, so dass ein bestimmter Teil der einfallenden Laserintensität (absichtlich) reflektiert wird und ein anderer Teil (absichtlich) transmittiert wird. Der Teil der einfallenden Laserintensität, der reflektiert wird, wird hierin auch als reflektierte Laserstrahlung bezeichnet. Der Teil der einfallenden Laserintensität, der transmittiert wird, wird hierin auch als transmittierte Laserstrahlung bezeichnet. Die einfallende Laserintensität wird hierin auch als Intensität des Laserstrahles bezeichnet. Auf Ausgangsseite des optisch transmittierenden Mediums ist optional gemäß einer Ausführungsform ebenfalls ein dielektrischer Schichtstapel aufgetragen der eine Antireflexions-Wirkung hat, so dass die ins Medium eingetretene Intensität mit geringen Verlusten wieder austreten kann. Gemäß einer Ausführungsform haben die transmittierte und die reflektierte Strahlung eine ähnliche (oder sogar gleiche) Strahlform und/oder ein ähnliches (oder sogar gleiches) Strahlprofil. Ferner haben gemäß einer Ausführungsform die transmittierte Strahlung und die reflektierte Strahlung die gleiche Polarisation. Dies hat den Vorteil, dass die Polarisation später nicht in einem der Strahlen wieder angepasst werden muss. Um gute Interferenz zu bekommen benötigen beide Teilstrahlen gemäß einer Ausführungsform die gleiche Polarisation.

Gemäß einer Ausführungsform ist der halbdurchlässige Spiegel konfiguriert, so dass ein signifikanter Teil (größer 10%) der einfallenden Laserintensität reflektiert sowie ein signifikanter Teil (größer 10 %) der einfallenden Laserintensität transmittiert wird. Vorteilhaft weist das optisch transmittierende Medium für den Laserstrahl eine geringe Absorption auf.

Gemäß einer Ausführungsform ist der Strahlteiler konfiguriert, so dass die Intensität der reflektierten Laserstrahlung und die Intensität der transmittierten Laserstrahlung gleich groß sind. Strahlteiler dieser Art werden als 50:50-Strahlteiler bezeichnet. Gemäß einer weiteren Ausführungsform ist der Strahlteiler ein unpolarisierender 50:50 Strahlteiler.

Gemäß einer Ausführungsform ist der Strahlteiler eingerichtet und angeordnet, so dass der Laserstrahl bei einem Einfall auf den ersten Bereich (des Eingangs) eine erste Intensitätsverteilung unter den mindestens zwei Teilstrahlen erzeugt und bei einem Einfall auf den zweiten Bereich (des Eingangs) eine zweite Intensitätsverteilung unter den mindestens zwei Teilstrahlen erzeugt. Gemäß einer Ausführungsform weichen die erste Intensitätsverteilung und die zweite Intensitätsverteilung um weniger als 10 % voneinander ab. Mit anderen Worten ist gemäß einer Ausführungsform die Intensitätsverteilung in den mindestens zwei Teilstrahlen im Rahmen eines Toleranzbereichs von 10 % unabhängig von dem Zustand des Laserstrahles.

Gemäß einer Ausführungsform führt eine Bearbeitung eines Objektes mit einer Laserbearbeitungsvorrichtung, wie sie hierin beschrieben ist, oder mit einem Verfahren, wie es hierin beschrieben ist, dazu, dass das Objekt mit einer Oberflächenstruktur gemäß Ausführungsformen der hierin offenbarten Gegenstände ausgestattet wird.

Gemäß einer Ausführungsform weist ein Objekt eine Oberfläche auf, welche eine periodische Oberflächenstruktur aufweist, wobei die Oberflächenstruktur eine Umfangslinie definiert, welche eine Einhüllende der Oberflächenstruktur ist, und wobei die Umfangslinie mindestens abschnittsweise in einem Umfangslinienabschnitt eine Form aufweist, die eine periodische Wiederholung eines Grundelements ist, und wobei sich eine Periodizität der Oberflächenstruktur von einer Periodizität des Umfangslinienabschnitts unterscheidet.

Insbesondere kann ein Randbereich der Oberflächenstruktur die Querschnittsform des Laserspots (bzw. des hierdurch erzeugten Bearbeitungsspots) widerspiegeln.

Gemäß einer Ausführungsform weist die Oberflächenstruktur mindestens eines der folgenden Merkmale auf: (i) die Oberflächenstruktur weist eine Vielzahl von parallelen Gräben auf; (ii) das Grundelement weist mindestens einen bogenförmigen Abschnitt (beispielsweise einen einzigen oder zwei oder mehr bogenförmigen Abschnitte) auf; (iii) der Umfangslinienabschnitt ist ein erster Umfangslinienabschnitt, das Grundelement ist ein erstes Grundelement und die Umfangslinie weist einen zweiten Umfangslinienabschnitt auf, welcher dem ersten Umfangslinienabschnitt gegenüberliegt und welcher eine periodische Wiederholung eines zweiten Grundelementes ist, und wobei sich eine Periodizität der Oberflächenstruktur von einer Periodizität des zweiten Umfangslinienabschnitts unterscheidet.

Gemäß einer weiteren Ausführungsform weist ein Objekt eine Oberfläche auf, die eine Oberflächenstruktur aufweist, wobei die Oberflächenstruktur eine maximale Tiefenerstreckung bezüglich der Oberfläche hat; eine Tiefenerstreckung der Oberflächenstruktur von einer ersten Position an einem Rand der Oberflächenstruktur bis zu einer zweiten Position auf 80 % der maximalen Tiefenerstreckung zunimmt; und ein Abstand zwischen der ersten Position und der zweiten Position mindestens 100 $\mu$m beträgt. Mit anderen Worten nimmt eine Tiefenerstreckung der Oberflächenstruktur von einer ersten Position an einem Rand der Oberflächenstruktur bis zu einer zweiten Position auf höchstens 80 % der maximalen Tiefenerstreckung zu, wobei ein Abstand zwischen der ersten Position und der zweiten Position 100 $\mu$m beträgt.

Die langsame Zunahme der Tiefenerstreckung der Oberflächenstruktur ausgehend von einem Rand der Oberflächenstruktur (80 % der maximalen Tiefenerstreckung werden erst nach 100 $\mu$m oder mehr erreicht) kann strömungstechnisch vorteilhaft sein, insbesondere wenn die Oberflächenstruktur eine Riblet-Struktur ist, insbesondere eine Riblet-Struktur wie sie hierin beschrieben ist. Gemäß einer Ausführungsform erfolgt die langsame Zunahme der Tiefenerstreckung, wie sie hierin beschrieben ist, mindestens in einer Richtung, die beispielsweise parallel zu einer Strömungsrichtung ist, in welcher die Oberflächenstruktur angeströmt werden soll.

DETAILLIERTE BESCHREIBUNG

Nachfolgend werden exemplarische Ausführungsformen der hierin offenbarten Gegenstände mit Bezug auf die Zeichnungen beschrieben. Es wird angemerkt, dass in verschiedenen Figuren ähnliche oder identische Elemente oder Komponenten teilweise mit denselben Bezugszahlen versehen sind, oder mit Bezugszahlen, die sich nur in der ersten Ziffer unterscheiden. Merkmale bzw. Komponenten, die mit den entsprechenden Merkmalen bzw. Komponenten in einer anderen Figur gleich oder zumindest funktionsgleich sind, werden nur bei ihrem ersten Auftreten in dem nachfolgenden Text detailliert beschrieben und die Beschreibung wird bei nachfolgendem Auftreten dieser Merkmale und Komponenten (bzw. der entsprechenden Bezugszahlen) nicht wiederholt. Die vorstehenden Definitionen gelten gemäß einer Ausführungsform für die nachfolgenden Ausführungsformen, und umgekehrt. Ferner sind die vorstehend beschriebenen Merkmale und Ausführungsformen mit den nachfolgend beschriebenen Merkmalen und Ausführungsformen kombinierbar.

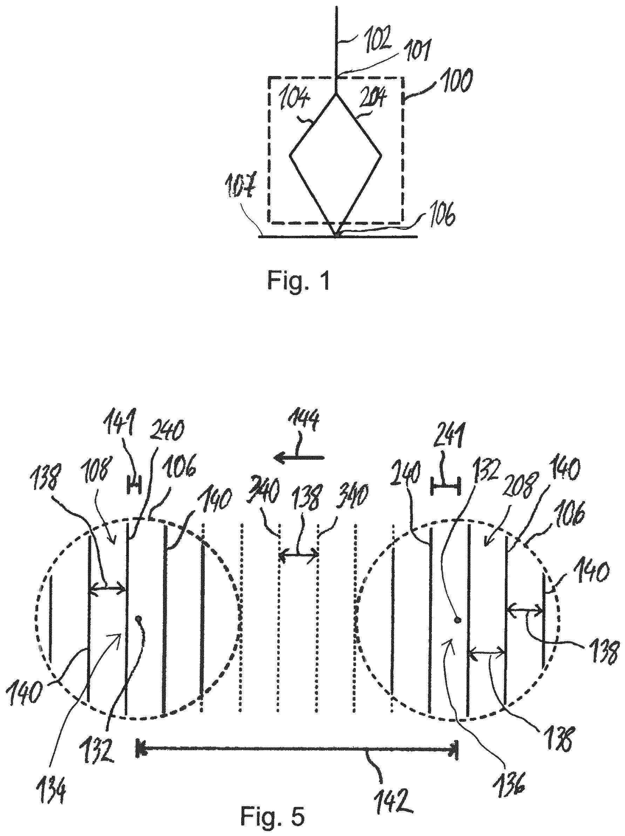

Fig. 1 zeigt schematisch ein Funktionsprinzip einer optischen Anordnung 100 gemäß Ausführungsformen der hierin offenbarten Gegenstände. Gemäß einer Ausführungsform weist die optische Anordnung 100 einen Eingang 101 zum Empfangen eines Laserstrahles 102 auf. Gemäß einer Ausführungsform ist die optische Anordnung 100 konfiguriert, um den Laserstrahl 102 in mindestens zwei (beispielsweise zwei) Teilstrahlen 104, 204, zu teilen und die Teilstrahlen 104, 204 wieder zu einem Laserspot 106 zusammen zu führen, zur Erzeugung eines Interferenzmusters in dem Laserspot 106. Gemäß einer Ausführungsform sind die Strahlungswege der Teilstahlen gleich lang oder nahezu gleich lang, beispielsweise gleich lang innerhalb eines Toleranzfensters von $\pm\,5\,\%$. Bei einem realen Aufbau mit endlichem Strahldurchmesser ergibt sich die Interferenz insbesondere durch den Winkel zwischen den Teilstrahlen.

Gemäß einer Ausführungsform hat ein erster Teilstrahl 104 der beiden Teilstrahlen eine erste optische Weglänge $l1$ und ein zweiter Teilstrahl 204 der Teilstrahlen hat eine zweite optische Weglänge $l2$. Hierdurch ergibt sich eine Weglängendifferenz $DI = l2 - l1$ der Teilstrahlen. Eine Änderung dieser Weglängendifferenz $DI$ führt zu der Abstandsänderung $DP$, wie sie hierin beschrieben ist. Gemäß einer Ausführungsform wird der Laserspot 106 auf eine Oberfläche 107 gerichtet.

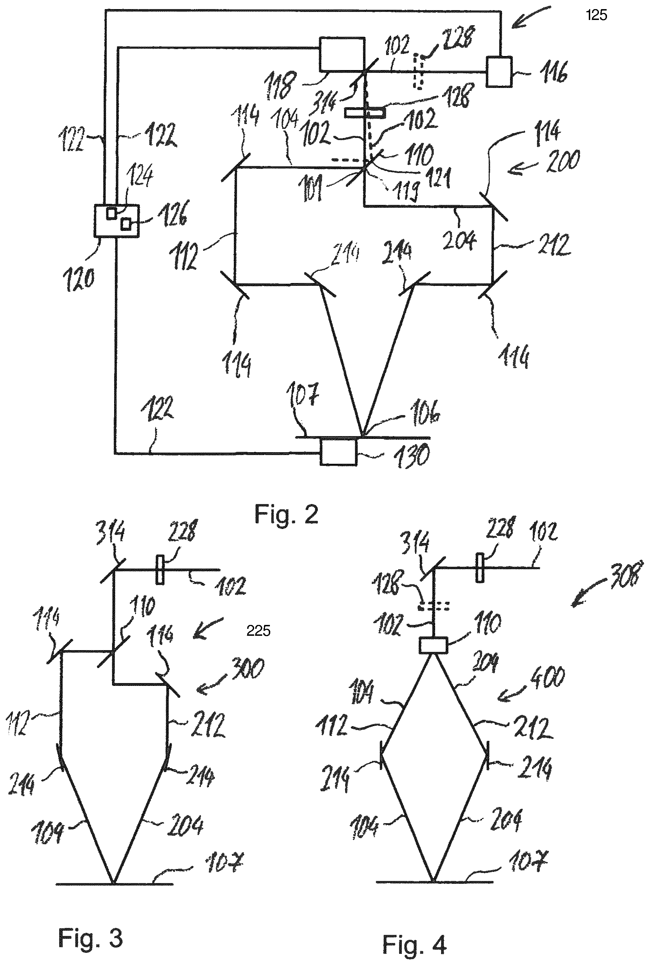

Fig. 2 zeigt eine Laserbearbeitungsvorrichtung 125 gemäß Ausführungsformen der hierin offenbarten Gegenstände.

Gemäß einer Ausführungsform weist die Laserbearbeitungsvorrichtung 125 eine optische Anordnung 200 auf. Gemäß einer Ausführungsform weist die optische Anordnung 200 einen Strahlteiler 110 auf, welcher einen Laserstrahl 102 in zwei Teilstrahlen 104, 204 teilt. Gemäß einer Ausführungsform ist der Strahlteilers 110 ein halbdurchlässiger Spiegel, beispielsweise wie in Fig. 2 dargestellt. Gemäß einer Ausführungsform ist ein Eingang 101 der optischen Anordnung 200 durch den Strahlteiler 110 gebildet. Gemäß einer weiteren Ausführungsform definiert die optische Anordnung 200 für jeden der Teilstrahlen 104, 204 einen Strahlungsweg 112, 212. Gemäß einer Ausführungsform weisen die mindestens zwei Strahlungswege einen ersten Strahlungsweg 112 und einen zweiten Strahlungsweg 212 auf. Gemäß einer weiteren Ausführungsform weist mindestens einer der Strahlungswege (beispielsweise jeder Strahlungsweg 112, 212) mindestens ein optisches Element, beispielsweise mindestens einen Spiegel 114, 214 auf. Gemäß einer Ausführungsform können drei Spiegel 114, 214 vorgesehen sein, beispielsweise wie in Fig. 2 dargestellt. Gemäß einer Ausführungsform definiert der mindestens eine Spiegel 114, 214 den Verlauf des betreffenden Strahlungsweges 112, 212 durch die optische Anordnung 200. Gemäß einer Ausführungsform ist die optische Anordnung 200 konfiguriert (beispielsweise durch Anordnung und/oder Ausrichtung des mindestens einen optischen Elements), um die Teilstrahlen 112, 212 zu einem Laserspot 106 zusammenzuführen. Gemäß einer Ausführungsform erfolgt das Zusammenführen der Teilstrahlen durch geeignete optische Elemente, beispielsweise Spiegel 214, beispielsweise wie in Fig. 2 dargestellt.

Gemäß einer Ausführungsform wird die optische Anordnung 200 bezüglich einer Oberfläche 107 eines Objekts positioniert, so dass der Laserspot 106 und das Interferenzmuster auf der Oberfläche 107 erzeugt werden, zur Bearbeitung der Oberfläche 107 mit dem Interferenzmuster. Beispielsweise erfolgt mit dem Interferenzmuster eine Strukturierung der Oberfläche 107. Dies wird auch als direkte Interferenzstrukturierung bezeichnet.

Gemäß einer Ausführungsform weist die Laserbearbeitungsvorrichtung eine Laserquelle 116 auf zur Erzeugung des Laserstrahles 102. Gemäß einer weiteren Ausführungsform ist die Laserquelle 116 extern zu der Laserbearbeitungsvorrichtung angeordnet und mit dieser koppelbar.

Gemäß einer Ausführungsform ist der Laserstrahl ein $CO_2$-Laserstrahl, insbesondere ein $CO_2$ Laserstrahl mit einer Leistung von mindestens 800 W (800 Watt). Entsprechend ist gemäß einer Ausführungsform die Laserquelle eine $CO_2$-Laserquelle. Gemäß einer Ausführungsform ist die $CO_2$-Laserquelle konfiguriert, um im Dauerstrich oder mit einer Pulsdauern < 1 ms (kleiner 1 Millisekunde) betrieben zu werden.

Gemäß einer weiteren Ausführungsform ist die Laserbearbeitungsvorrichtung eingerichtet, um eine Lackoberfläche zu strukturieren, insbesondere eine ausgehärtete Lackoberfläche.

Gemäß der Erfindung weist die Laserbearbeitungsvorrichtung mindestens einen beweglichen Spiegel 314 und eine Aktoranordnung 118 zur Steuerung von dem mindestens einen beweglichen Spiegel 314 auf. Gemäß der Erfindung ist der mindestens eine bewegliche Spiegel 314 angeordnet, um einen Zustand des Laserstrahles an dem Eingang 101 zu ändern, beispielsweise um eine Position des Laserstrahles an dem Eingang 101 und/oder einen Einfallswinkel des Laserstrahles 102 bezüglich des Eingangs 101 zu ändern. Beispielsweise kann durch Verschwenken von dem mindestens einen beweglichen Spiegel 314 die Position und der Einfallswinkel des Laserstrahles 102 bezüglich des Eingangs veränderbar sein, beispielsweise wie in Fig. 2 durch einen ersten Zustand des Laserstrahles an dem Eingang (durchgezogene Linie bei 102) und einen zweiten Zustand des Laserstrahles an dem Eingang (gestrichelte Linie bei 102) dargestellt. Hierbei ist der Laserstrahl 102 in dem ersten Zustand in einem ersten Bereich 119 des halbdurchlässigen Spiegels 110 (der gemäß einer Ausführungsform als Eingang der optischen Anordnung betrachtet wird) positioniert und in dem zweiten Zustand in einem zweiten Bereich 121 des halbdurchlässigen Spiegels 110.

Gemäß einer Ausführungsform ist die optische Anordnung 200 so konfiguriert, dass der erste Zustand ein erstes Interferenzmuster erzeugt und der zweite Zustand ein zweites Interferenzmuster erzeugt, wobei das zweite Interferenzmuster das erste Interferenzmuster in Phase fortsetzt. Gemäß einer Ausführungsform erfolgt dieses in-Phase-Fortsetzen des (ersten) Interferenzmusters selbst bei einer kontinuierlichen Änderung des Zustands des Laserstrahles an dem Eingang 101, wodurch effektiv ein in seinen Abmessungen vergrößertes, resultierendes Interferenzmuster bei gleichzeitiger Erzielung einer definierten Phasenbeziehung der Interferenzmaxima und Interferenzminima in dem vergrößerten Interferenzmuster erzielbar ist. Verglichen mit einer Auffächerung eines einzigen Laserspots wird durch das in-Phase-Fortsetzen des Interferenzmusters eine homogenere Bearbeitung erzielt, da ein einziger Laserspot typischerweise ein gaußförmiges Strahlprofil aufweist. Gemäß einer Ausführungsform wird die homogene Bearbeitung einer Oberfläche erreicht durch eine gleichmäßige integrierte Gesamtintensität pro Einheitsfläche, wobei die erzeugten Intensitätsmaxima in Phase (phasengetreu) sind.

Das resultierende Interferenzmuster kann beispielsweise durch Verschwenken des Laserstrahles 102 über den Eingang 101 erzeugt werden, d. h. gemäß einer Ausführungsform durch Verschwenken des Laserstrahles 102 über den Strahlteiler 110.

Gemäß einer Ausführungsform ist ein optisches Element 128, insbesondere ein optisches Element zum Fokussieren des Laserstrahles, vorgesehen, beispielsweise als Teil der optischen Anordnung oder als Teil der Laserbearbeitungsvorrichtung. Gemäß einer Ausführungsform ist das optische Element zum Fokussieren des Laserstrahles eine Linse, beispielsweise eine Linse, welche zwischen dem mindestens einen beweglichen Spiegel 314 und dem Strahlteiler 110 angeordnet ist, beispielsweise wie in Fig. 2 dargestellt. Gemäß einer weiteren Ausführungsform ist das optische Element 128 ein Fokusshifter. Gemäß einer weiteren Ausführungsform kann (beispielsweise alternativ oder zusätzlich zu dem optischen Element 128) zwischen der Laserquelle und dem mindestens einen beweglichen Spiegel 314 ein optisches Element 228, insbesondere ein optisches Element zur Fokussierung des Laserstrahles, angeordnet sein, beispielsweise wie in zwei gestrichelt dargestellt.

Gemäß einer weiteren Ausführungsform weist die Laserbearbeitungsvorrichtung 125 eine Steuervorrichtung 120 auf zur Steuerung von Komponenten der Laserbearbeitungsvorrichtung (beispielsweise der Aktoranordnung 118 und, falls vorhanden, der Laserquelle 116) durch Steuersignale 122. Gemäß einer Ausführungsform weist die Steuervorrichtung eine Prozessorvorrichtung 124 und eine Speichervorrichtung 126 zur Speicherung eines Computerprogramms, welches auf der Prozessorvorrichtung 124 ausführbar ist, zum dadurch Realisieren von Funktionen von Ausführungsformen der hierin offenbarten Gegenstände. Gemäß einer weiteren Ausführungsform ist eine weitere Aktoranordnung 130 vorgesehen zur Positionierung der optischen Anordnung 200 und der Oberfläche 107 relativ zueinander. Dies kann beispielsweise vorteilhaft sein bei einer großflächigen Laserbearbeitung, bei welcher beispielsweise das resultierende Interferenzmuster über die Oberfläche 107 bewegt wird. Gemäß einer Ausführungsform kann die weitere Aktoranordnung 130 von der Steuervorrichtung 120 der Laserbearbeitungsvorrichtung über Steuersignale 122 gesteuert sein, oder alternativ von einer externen Steuervorrichtung (in Fig. 2 nicht dargestellt). Es sollte sich verstehen dass die (weitere) Aktoranordnung 130 in den Zeichnungen lediglich exemplarisch dargestellt ist, insbesondere bezüglich der Position. Beispielsweise kann vorgesehen sein, dass die optische Anordnung und gegebenenfalls auch weitere Komponenten der Laserbearbeitungsvorrichtung, beispielsweise der mindestens eine bewegliche Spiegel 314, die Aktoranordnung 118, die Optik 128 oder die Optik 228, gegenüber der Laserquelle 116 und der Oberfläche 107 verschiebbar ist. Beispielsweise kann die optische Anordnung 100 (und optional die Optik 228) auf einem Roboterarm montiert sein, zur Positionierung (und gegebenenfalls Bewegung) dieser Komponenten über die Oberfläche 107. Der Roboterarm bildet in diesem Fall die Aktoranordnung 130 oder einen Teil der Aktoranordnung 130.

Fig. 3 zeigt einen Teil einer Laserbearbeitungsvorrichtung 225 gemäß Ausführungsformen der hierin offenbarten Gegenstände.

Die Laserbearbeitungsvorrichtung 225 kann eines oder mehrere Merkmale aufweisen, die mit Bezug auf die Laserbearbeitungsvorrichtung 125 aus Fig. 2 beschrieben wurden, auch wenn die betreffenden Merkmale in Fig. 3 nicht dargestellt sind.

Gemäß einer Ausführungsform weist die Laserbearbeitungsvorrichtung 225 eine optische Anordnung 300 auf.

Im Unterschied zu der optischen Anordnung 200, die mit Bezug auf Fig. 2 beschrieben wurde, weist die optische Anordnung 300 in jedem der Strahlungswege 112, 212 zwei Spiegel 114, 214 auf. Ferner ist gemäß einer Ausführungsform das optische Element 228 zur Fokussierung des Laserstrahles 102 in Strahlrichtung vor dem mindestens einen beweglichen Spiegel 314 angeordnet. Ferner ist gemäß einer Ausführungsform zwischen dem mindestens einen beweglichen Spiegel 314 und dem Strahlteiler 110 (welcher durch einen halbdurchlässigen Spiegel realisiert sein kann, beispielsweise wie in Fig. 3 dargestellt) kein optisches Element angeordnet.

Fig. 4 zeigt einen Teil einer Laserbearbeitungsvorrichtung 308 gemäß Ausführungsformen der hierin offenbarten Gegenstände.

Die Laserbearbeitungsvorrichtung 308 kann eines oder mehrere Merkmale aufweisen, die mit Bezug auf die Laserbearbeitungsvorrichtung 125 aus Fig. 2 beschrieben wurden, auch wenn die betreffenden Merkmale in Fig. 4 nicht dargestellt sind.

Gemäß einer Ausführungsform weist die Laserbearbeitungsvorrichtung 308 eine optische Anordnung 400 auf. Gemäß einer Ausführungsform ist der Strahlteiler 110 der optischen Anordnung durch ein diffraktives optisches Element (DOE) gebildet, welches den Laserstrahl 102 in die mindestens zwei Teilstrahlen 104, 204 teilt.

Gemäß einer Ausführungsform ist das diffraktive optische Element konfiguriert, so dass die aus ihm austretenden mindestens zwei Teilstrahlen 104, 204 einen spitzen Winkel einschließen, beispielsweise wie in Fig. 4 dargestellt.

Gemäß einer Ausführungsform weist jeder der Strahlungswege 112, 212 der mindestens zwei Teilstrahlen 104, 204 ein einziges optisches Element, beispielsweise einen einzigen Spiegel 214 auf.

Die optischen Anordnungen 300, 400, die mit Bezug auf die Fig. 3 und Fig. 4 beschrieben wurden, erfordern vergleichsweise wenige optische Elemente in den Strahlungswege liegen 112, 212, allerdings auf Kosten eines sehr flachen Einfallswinkels auf die letzten Spiegel 214, wodurch sich eine Verzerrung des betreffenden Teilstrahls 104, 204 ergeben kann.

Fig. 5 zeigt ein erstes Interferenzmuster 108 und ein zweites Interferenzmuster 208, wie sie von einer Laserbearbeitungsvorrichtung gemäß Ausführungsformen der hierin offenbarten Gegenstände erzeugt werden können.

Gemäß einer Ausführungsform wird das erste Interferenzmuster 108 von einem Laserspot 106 gebildet, dessen Zentrum 132 an einer ersten Position 134 liegt, während das zweite Interferenzmuster 208 von dem Laserspot 106 gebildet wird, wobei das Zentrum 132 sich an einer zweiten Position 136 befindet. Die Aussage, dass "das Zentrum 132 des Laserspots 106 an einer bestimmten Position liegt" (beispielsweise der ersten Position 134), wird hierin auch abgekürzt mit der Aussage, dass "der Laserspot 106 an der bestimmten Position liegt". Die beiden Formulierungen sind daher als gleichwertig anzusehen. Gemäß einer Ausführungsform wurde der Laserspot 106 an der ersten Position 134 und an der zweiten Position 136 dadurch erzeugt, dass für die erste Position 134 ein erster Zustand (gemäß einer Ausführungsform im Hinblick auf Position und Einfallswinkel des Laserstrahles) für den Laserstrahl am Eingang der optischen Anordnung eingestellt wurde, während für die zweite Position 136 des Laserspots 106 ein zweiter Zustand für den Laserstrahl am Eingang der optischen Anordnung eingestellt wurde.

Die Zustandsänderung (beispielsweise die Änderung von Position und Einfallswinkel) des Laserstrahles resultiert somit in einer Positionsänderung 142 (hierin auch mit DS bezeichnet) einer Position des Zentrums 132 des Laserspots 106.

Gemäß einer Ausführungsform ist die optische Anordnung, welche den Laserspot 106 erzeugt, so konfiguriert, dass das zweite Interferenzmuster 208 das erste Interferenzmuster 108 in Phase fortsetzt, beispielsweise wie in Fig. 5 dargestellt. Die in-Phase-Fortsetzung des Interferenzmusters äußert sich bei einer Zwei-Strahl-Interferenz beispielsweise in einem konstanten Abstand 138 (hierin auch mit L bezeichnet) zwischen zwei benachbarten Interferenzmaxima "auch über die Grenzen eines einzelnen Laserspots hinweg".

Die Phasenlage der Interferenzmaxima 140 des zweiten Interferenzmusters 208 ist daher im Einklang mit der Phasenlage der Interferenzmaxima 140 des ersten Interferenzmusters 108. Mit anderen Worten erfolgt durch die optische Anordnung eine Änderung eines ersten Abstands 141 zwischen dem Zentrum 132 des Laserspots 106 und einem in einer vorbestimmten Richtung 144 nächstliegenden Interferenzmaximum 240 an der ersten Position 134 in einen zweiten Abstand 241 zwischen dem Zentrum 132 des Laserspots 106 und dem in der vorbestimmten Richtung 144 nächstliegenden Interferenzmaximum 240 an der zweiten Position 136. Hierbei entspricht die Differenz des ersten Abstands 141 und des zweiten Abstands 241 der Abstandsänderung DP.

Gemäß einer Ausführungsform stellt die optische Anordnung die in-Phase-Fortsetzung des ersten Interferenzmusters für eine kontinuierliche Positionsänderung (jedenfalls innerhalb eines Gültigkeitsbereichs, beispielsweise eines Gültigkeitsbereichs für die Positionsänderung) sicher. Auf diese Weise ergibt sich bei einer kontinuierlichen Positionsänderung des Zentrums 132 des Laserspots 106 von der ersten Position 134 zu der zweiten Position 136 ein kontinuierliches Überstreichen der Fläche zwischen dem ersten Interferenzmuster 108 und dem zweiten Interferenzmuster 208. Da an jeder Position die Phasentreue sichergestellt ist, ergeben sich auch zwischen der ersten Position und der zweiten Position Interferenzmaxima 340 (in Fig. 5 gestrichelt dargestellt), welche die gleiche Phasenbeziehung aufweisen, wie die Interferenzmaxima 140 des ersten Interferenzmusters 108 und die Interferenzmaxima 140 des zweiten Interferenzmusters 208. Mit anderen Worten sind alle Interferenzmaxima 140, 240, 340, die sich durch eine kontinuierliche Positionsänderung zwischen der ersten Position 134 und der zweiten Position 136 ergeben, in Phase, beispielsweise wie in Fig. 5 dargestellt.

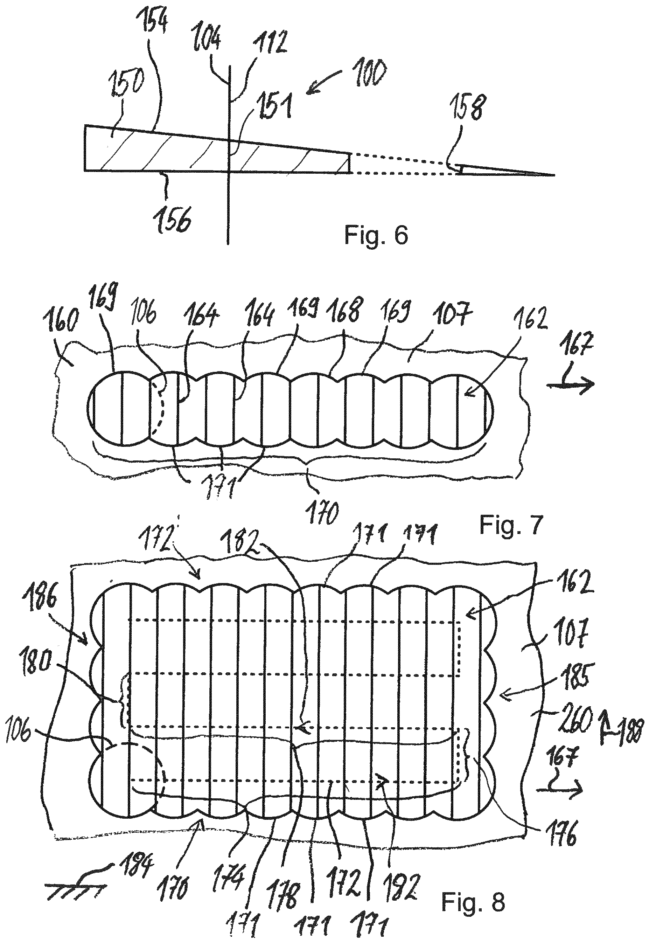

Fig. 6 zeigt in einer Schnittdarstellung einen Teil einer optischen Anordnung 100 einer Laserbearbeitungsvorrichtung gemäß Ausführungsformen der hierin offenbarten Gegenstände.

Gemäß einer Ausführungsform weist die optische Anordnung 100 mindestens ein transmittierendes optisches Element 150 auf, welches in einem Strahlungsweg 112 von mindestens einem der Teilstrahlen, beispielsweise dem Teilstrahl 104 aus Fig. 1 liegt. Gemäß einer Ausführungsform weist das transmittierende optische Element 150 ein durchstrahltes Flächenpaar auf, welches eine erste Fläche 154 und eine zweite Fläche 156 umfasst. Gemäß einer weiteren Ausführungsform schließt das Flächenpaar 154, 156 einen Winkel 158 ein, der gemäß einer Ausführungsform höchstens 10 Grad beträgt. Fig. 7 zeigt einen Teil eines Objektes 160 gemäß Ausführungsformen der hierin offenbarten Gegenstände.

Das Objekt weist eine Oberfläche 107 auf, die eine periodische Oberflächenstruktur 162 aufweist. Die Oberflächenstruktur 162 weist eine Vielzahl von parallelen Gräben auf, die in Fig. 7 durch eine Vielzahl von parallelen Linien 164 veranschaulicht sind. Es wird darauf hingewiesen, dass die Linien 164 nicht die Dimensionen der Gräben der Oberflächenstruktur 162 darstellen sondern lediglich die Periodizität veranschaulichen sollen. Tatsächlich sind gemäß einer Ausführungsform, beispielsweise in einer Riblet-Anwendung, die Gräben breiter als die zwischen den Gräben verbleibenden Rippen. In diesem Sinne können gemäß einer Ausführungsform die Linien 164 beispielsweise eine Mittellinie (oder eine Schwerpunktslinie) der Gräben repräsentieren. Gemäß einer Ausführungsform ist die Oberflächenstruktur eine Ribletstruktur mit einer Vielzahl von Riblets, wie sie in der WO 2018/197555 A1 beschrieben sind d. h. eine Oberflächenstruktur, welche gegenüber einer glatten Oberfläche einen Strömungswiderstand der Oberfläche senkt. Insbesondere bezüglich der Anwendung, der Funktion, der Form, der Abmessungen, der Eigenschaften, etc. der Riblets wird ausdrücklich auf die WO 2018/197555 A1 verwiesen, deren gesamte Offenbarung, insbesondere die Abmessungen und Anwendungen der Riblets, hierin durch Bezugnahme eingeschlossen wird.

Wie für Riblets üblich, weisen in einer Ausführungsform die Gräben jeweils seitliche Wände auf. Die benachbarten Wände von jeweils zwei nebeneinander liegenden Gräben bilden daher zwei voneinander abgewandte Flanken einer Rippe zwischen den zwei Gräben. Mit anderen Worten wird durch die Vielzahl von Gräben eine Vielzahl von Rippen in der Oberfläche erzeugt, die bei geeigneter Abmessung als Riblets wirken (d. h. einen Strömungswiderstand über die Oberfläche reduzieren), beispielsweise wie dies in der oben zitierten WO 2018/197555 A1 beschrieben ist. Gemäß einer Ausführungsform schließen die Flanken der Rippen einen spitzen Winkel ein. Insbesondere sind die Rippen gemäß einer Ausführungsform spitz zulaufend ausgebildet.

Gemäß einer Ausführungsform erstrecken sich die Rippen im Wesentlichen parallel zueinander und insbesondere parallel zu einer Strömungsrichtung einer zu erwartenden Strömung über die Oberfläche.

Gemäß einer Ausführungsform ist die periodische Oberflächenstruktur 162 durch eine Belichtung mit einem Laserspot erzeugt, der in Fig. 7 in einer ersten Position durch die gestrichelte Linie bei 106 veranschaulicht ist. Gemäß einer Ausführungsform ist die Oberflächenstruktur 162 erzeugt durch ein Erzeugen des Laserspots 106 an verschiedenen Positionen auf der Oberfläche 107. Gemäß einer Ausführungsform weist der Laserspot an jeder Position ein Interferenzmuster auf, welches das Interferenzmuster des Laserspots an der ersten Position in Phase fortsetzt, beispielsweise wie in Fig. 7 dargestellt. Gemäß einer Ausführungsform wird durch jedes Interferenzmuster die Oberfläche 107 bearbeitet, wobei jedes Interferenzmuster einen Bearbeitungsspot 169 in der Oberfläche 107 erzeugt. Durch eine Aneinanderreihung von Interferenzmustern bzw. Bearbeitungsspots 169 ergibt sich gemäß einer Ausführungsform die Oberflächenstruktur 162. Falls die Laserquelle eine gepulste Laserquelle ist, ergeben sich bei einer kontinuierlichen Bewegung des Laserstrahles über den Eingang der optischen Anordnung (in Fig. 7 nicht dargestellt) diskrete Bearbeitungsspots 169, die sich bei geeigneter Wahl von beispielsweise Pulsfrequenz des Lasers und Bewegungsgeschwindigkeit des Laserstrahles über den Eingang der optischen Anordnung überlappen und voneinander unterscheidbar sind, beispielsweise wie in Fig. 7 dargestellt.

Gemäß einer Ausführungsform können die Bearbeitungsspots 169 entlang einer geradlinigen Linie erzeugt sein, beispielsweise in einer Richtung 167 über die Oberfläche 107, beispielsweise wie in Fig. 7 dargestellt.

Im Ergebnis definieren die überlappenden Bearbeitungsspots 169 eine Umfangslinie 168, welche eine Einhüllende der Oberflächenstruktur ist und welche gemäß einer Ausführungsform zumindest in einem Umfangslinienabschnitt, beispielsweise in einem Umfangslinienabschnitt 170, der in Fig. 7 veranschaulicht ist, eine Form aufweist, die eine periodische Wiederholung eines Grundelementes ist, von denen einige in Fig. 7 mit der Bezugszahl 171 bezeichnet sind. Gemäß einer Ausführungsform ist das Grundelement mindestens abschnittsweise bogenförmig, beispielsweise kreisbogenförmig, wie in Fig. 7 dargestellt. Gemäß einer weiteren Ausführungsform kann das Grundelement ein Segment einer Ellipse oder einen anders geformtes Grundelement sein. Gemäß einer Ausführungsform, beispielsweise wenn die Oberflächenstruktur 162 einer Strömung ausgesetzt werden soll, kann ein bogenförmiges Grundelement oder ein bogenförmiger Abschnitt des Grundelements dazu führen, dass die Strömung nicht entlang einer geraden Linie und somit in einem sehr schmalen Eintrittsbereich in die Oberflächenstruktur eintritt, sondern über einen Eintrittsbereich, welcher in Strömungsrichtung ausgedehnt ist. Dies kann strömungstechnisch vorteilhaft sein.

Gemäß einer Ausführungsform ist eine Periodizität der periodischen Oberflächenstruktur 162 verschieden von einer Periodizität des Umfangslinienabschnitts 170, Beispielsweise wie in Fig. 7 dargestellt. Gemäß einer Ausführungsform rührt der Unterschied in der Periodizität der Oberflächenstruktur 162 und des Umfangslinienabschnitts 170 daher, dass die Periodizität der Oberflächenstruktur 162 durch die Interferenz der mindestens zwei Teilstrahlen definiert ist, wohingegen die Periodizität des Umfangslinienabschnitts 170 durch die Abmessungen des Laserspots und die Überlappung der damit erzeugten Bearbeitungsspots 169 definiert ist.

Fig. 8 zeigt einen Teil eines weiteren Objektes 260 gemäß Ausführungsformen der hierin offenbarten Gegenstände.

Gemäß einer Ausführungsform weist eine Oberfläche 107 des Objektes 260 eine periodische Oberflächenstruktur 162 auf, die durch Bewegung des Laserspots 106 in zwei voneinander linear unabhängigen Richtungen erzeugt wurde. Beispielsweise kann die Laserbearbeitungsvorrichtung konfiguriert sein, um den Laserspot 106 längs eines mäanderförmigen Weges 172 zu bewegen, beispielsweise wie in Fig. 8 dargestellt. Die Bewegung des Laserspots 106 in zwei voneinander linear unabhängigen Richtungen kann beispielsweise realisiert sein durch ein Positionieren des Laserspots entlang eines ersten Wegabschnitts 174 parallel zu einer ersten Richtung 167 und ein Positionieren des Laserspots entlang eines zweiten Wegabschnitts 176, der schräg (beispielsweise senkrecht) zu dem ersten Wegabschnitts 174 verläuft.

Ferner kann vorgesehen sein, dass die Bewegung des Laserspots 106 in zwei voneinander linear unabhängigen Richtungen zwei parallele Wegabschnitte aufweist, beispielsweise zwei parallele Wegabschnitte 174, 178 wie in Fig. 8 dargestellt. Gemäß einer Ausführungsform erfolgt die Bewegung in den beiden parallelen Wegabschnitten in entgegengesetzten Richtungen, in Fig. 8 angegeben bei 182 wodurch beispielsweise ein mäanderförmiger Weg realisierbar ist, beispielsweise wie in Fig. 8 dargestellt. Gemäß einer Ausführungsform kann die Bewegung des Laserspots in parallelen Wegabschnitten stets in derselben Richtung erfolgen (in Fig. 8 nicht dargestellt). Für eine Überlappung der Laserspots auf den parallelen Wegabschnitten ist dann eine Rückbewegung (entlang eines zweiten Wegabschnitts, in Fig. 8 nicht dargestellt) erforderlich, während welcher gemäß einer Ausführungsform der Laserstrahl abgeschaltet ist, so dass während der Rückbewegung kein Laserspot erzeugt wird. Ferner kann gemäß einer Ausführungsform vorgesehen sein, dass entlang des zweiten Wegabschnitts 176 der Laserstrahl abgeschaltet ist so dass entlang des zweiten Wegabschnitts kein Laserspot erzeugt wird. Beispielsweise kann vorgesehen sein, dass lediglich in den Endpunkten eines Wegabschnitts, beispielsweise des zweiten Wegabschnitts 176 der Laserstrahl angeschaltet ist und somit ein Laserspot in den Endpunkten erzeugt wird, beispielsweise wie in Fig. 8 dargestellt.

Gemäß einer Ausführungsform wird eine Positionierung des Laserspots entlang von parallelen Wegabschnitten, beispielsweise entlang der parallelen Wegabschnitte 174, 178 durch eine Bewegung des Laserstrahles über den Eingang der optischen Anordnung erzeugt, während eine Bewegung schräg zu den parallelen Wegabschnitten, beispielsweise entlang der Wegabschnitte 176, 180 durch eine Bewegung der Oberfläche 107 bezüglich eines Bezugspunktes 184 erfolgt. Dies hat den Vorteil, dass große Oberflächen bearbeitet werden können. Eine Bewegung der Oberfläche 107 bezüglich der optischen Anordnung kann beispielsweise kontinuierlich erfolgen, wobei gemäß einer Ausführungsform zur Realisierung eines vorbestimmten Weges (beispielsweise des mäanderförmig in Weges, wie er in Fig. 8 dargestellt ist) die Laserbearbeitungsvorrichtung konfiguriert ist, um eine Korrekturbewegung durch eine Bewegung der optischen Anordnung bezüglich des Bezugspunktes 184 auszuführen und dadurch den Laserspot entlang des vorbestimmten Weges zu positionieren. Gemäß einer weiteren Ausführungsform kann anstelle der Bewegung der Oberfläche 107 bezüglich des Bezugspunktes 184 die Laserbearbeitungsvorrichtung konfiguriert sein, um auch die Bewegung schräg zu den parallelen Wegabschnitten (zum Beispiel senkrecht zu dem parallelen Wegabschnitten) durch eine Bewegung des Laserstrahles über den Eingang der optischen Anordnung zu erzeugen. Allgemein kann beispielsweise die Aktoranordnung 118 und der mindestens eine bewegliche Spiegel 314 konfiguriert sein, um eine Bewegung des Laserstrahles 102 in zwei voneinander linear unabhängigen Richtungen zu ermöglichen. Gemäß einer Ausführungsform können die Aktoranordnung 118 und der mindestens eine bewegliche Spiegel 314 durch einen an sich bekannten Galvanometerscanner gebildet sein.

Gemäß einer Ausführungsform definiert die Oberflächenstruktur 162 einen ersten Umfangslinienabschnitt 170 einer einführenden Umfangslinie, wobei der Umfangslinienabschnitt 170 eine Form aufweist, die eine periodische Wiederholung eines Grundelementes 171 ist. Gemäß einer weiteren Ausführungsform weist die Oberflächenstruktur 162 einen zweiten Umfangslinienabschnitt 172 auf, der eine Form aufweist, die eine periodische Wiederholung eines Grundelements 171 ist, wobei der zweite Umfangslinienabschnitt 172 dem ersten Umfangslinienabschnitt 170 gegenüberliegt, beispielsweise wie in Fig. 8 dargestellt. Gemäß einer Ausführungsform ist der zweite Umfangslinienabschnitt 172 ein Spiegelbild des ersten Umfangslinienabschnitts 170, beispielsweise wie in Fig. 8 dargestellt.

Es versteht sich, dass unter bestimmten Bedingungen ein Umfangslinienabschnitt keine Form aufweist, die (erkennbar) eine periodische Wiederholung eines Grundelementes ist, beispielsweise wenn der Laserstrahl während der Positionierung des Laserspots 106 entlang des ersten Wegabschnitts 174 kontinuierlich (nicht gepulst) abgegeben wird oder wenn die Überlappung der Interferenzmuster der einzelnen Pulse sehr hoch ist. Allerdings kann in einem solchen Fall ein anderer Umfangslinienabschnitt 185, 186 durchaus eine Form aufweisen, die eine periodische Wiederholung eines Grundelementes ist, beispielsweise wenn bei einer Positionierung in einer Richtung 188 dieses anderen Umfangslinienabschnitts 185, 186 der kontinuierliche Laserstrahl abgeschaltet wird.

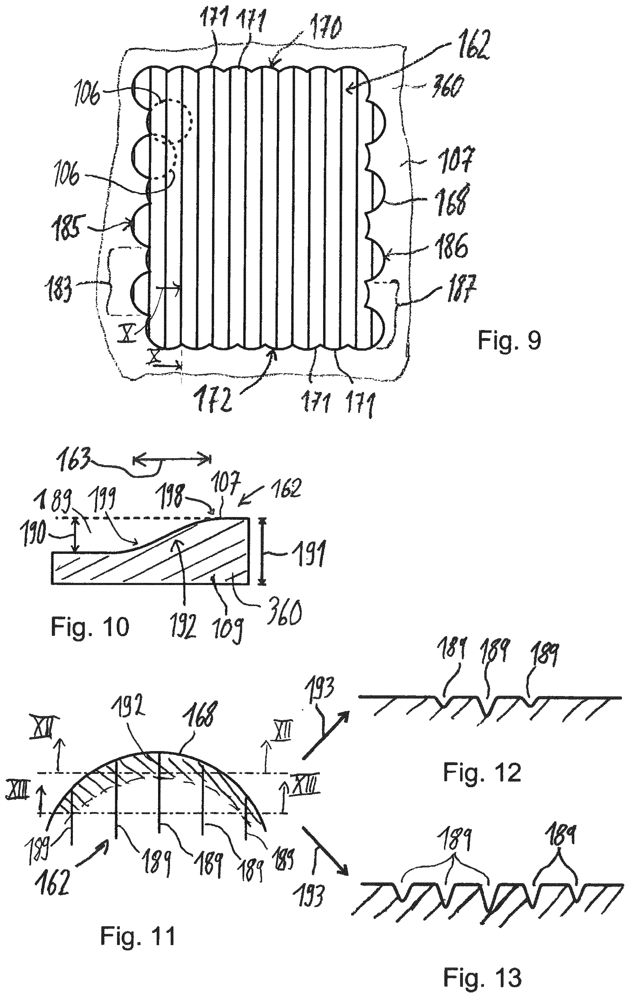

Fig. 9 zeigt einen Teil eines Objektes 360 gemäß Ausführungsformen der hierin offenbarten Gegenstände.

Ähnlich wie Fig. 8 zeigt auch Fig. 9 das Objekt 360 mit einer Oberfläche 107, welche eine periodische Oberflächenstruktur 162 aufweist, welche eine Umfangslinie 168 definiert, welche eine Einhüllende der Oberflächenstruktur 162 ist. Gemäß einer Ausführungsform weist die Umfangslinie 168 einen ersten Umfangslinienabschnitt 170 und einen zweiten Umfangslinienabschnitt 172 auf, welche eine periodische Wiederholung eines Grundelements 171 sind, wobei das Grundelement 171 gemäß einer Ausführungsform aus einem einzigen bogenförmigen Abschnitt besteht, beispielsweise wie in Fig. 9 dargestellt. Gemäß einer weiteren Ausführungsform weist die Umfangslinie 168 einen dritten Umfangslinienabschnitt 185 auf, der eine periodische Wiederholung eines Grundelements 183 ist, welches aus zwei bogenförmigen Abschnitten besteht, beispielsweise wie in Fig. 9 dargestellt. Gemäß einer weiteren Ausführungsform weist die Umfangslinie 168 einen vierten Umfangslinienabschnitt 186 auf, welcher eine periodische Wiederholung eines weiteren Grundelements 187 ist, welches aus zwei bogenförmigen Abschnitten besteht, beispielsweise wie in Fig. 9 dargestellt.

Fig. 10 zeigt eine Querschnittsansicht eines Teils der Oberflächenstruktur 162 aus Fig. 9 entlang der Schnittlinie X-X in Fig. 9.

Gemäß einer Ausführungsform ist die Oberfläche 107 von einer Lackschicht 109 gebildet, welche auf einem Körper des Objektes 360 (der Körper ist in Fig. 10 nicht dargestellt) gebildet ist. Gemäß einer Ausführungsform ist die Lackschicht 109 eine ausgehärtete Lackschicht, beispielsweise die Lackschicht eines Flugzeugs. Die Oberflächenstruktur 162 weist eine Vielzahl von Gräben 189 auf, von denen in Fig. 10 einer exemplarisch in Schnittdarstellung dargestellt ist. Gemäß einer Ausführungsform weist die Oberflächenstruktur und damit mindestens einer der Gräben 189 eine maximale Tiefenerstreckung (oder Tiefe) 190 auf, die gemäß einer Ausführungsform geringer ist als eine Dicke 191 der Lackschicht 109. Gemäß einer weiteren Ausführungsform nimmt eine Tiefenerstreckung der Oberflächenstruktur 162 von einer ersten Position 198 an einem Rand der Oberflächenstruktur 162 bis zu einer nächstgelegenen zweiten Position 199 auf 80 % der maximalen Tiefenerstreckung zu. "Nächstgelegen" in diesem Sinne bedeutet, dass, falls es mehrere zweite Positionen gibt, in denen die Tiefenerstreckung 80 % der maximalen Tiefenerstreckung beträgt, diejenige mit dem geringsten Abstand zu der ersten Position 198 ausgewählt wird. Gemäß einer weiteren Ausführungsform beträgt ein Abstand 163 zwischen der ersten Position 198 und der zweiten Position 199 mindestens 100 $\mu$m, beispielsweise mindestens 300 $\mu$m oder mindestens 500 $\mu$m.

Beispielsweise ist gemäß einer Ausführungsform die Tiefe 190 in einem Randbereich 192 des Grabens 189 reduziert und geht kontinuierlich gegen Null, d. h. auf das Niveau der Oberfläche 107, beispielsweise wie in Fig. 10 dargestellt. Die Ausgestaltung der Oberflächenstruktur 162 in ihrem Randbereich 192 ist gemäß einer Ausführungsform auf ein Einstichverhalten des Lasers zurückzuführen, wodurch in dem Randbereich 192 der Abtrag durch den Laserspot geringer ist, da der Laserspot in seinem Randbereich typischerweise eine geringere Intensität als im Zentrum des Laserspots aufweist (gemittelt über das Interferenzmuster des Laserspots). Das Einstichverhalten mit den hierin beschriebenen Charakteristika ist beispielsweise dadurch erzielbar, dass die Oberfläche durch eine Lackschicht gebildet ist und die Bearbeitung mit einem CO2-Laser erfolgt.

Gemäß einer Ausführungsform ist die Lackoberfläche eine Lackoberfläche, wie sie in der WO 2018/197555 A1 beschrieben ist. Insbesondere kann die Lackoberfläche durch einen Lack auf Polymerbasis, insbesondere auf Basis von Polyurethan oder Acryl oder Epoxy gebildet sein. Gemäß einer Ausführungsform ist der Lack ein Klarlack oder ein Decklack. Gemäß einer Ausführungsform weist ein Absorptionsspektrum des Lacks eine Überlappung mit dem Emissionsspektrum eines CO2-Lasers auf. Gemäß einer Ausführungsform ist der CO2-Laser mit einer Wellenlänge im Bereich zwischen 9 $\mu$m und 11 $\mu$m betreibbar.

Gemäß einer Ausführungsform enthält der Lack Pigmente, welche eine Färbung des Lacks beeinflussen. Typischerweise enthält ein Decklack solche Pigmente. Gemäß einer weiteren Ausführungsform ändern die Pigmente ein Absorptionsverhalten des Lacks für den Laserstrahl. Gemäß einer Ausführungsform kann das Einstichverhalten eines Lasers durch die Art und Konzentration der Pigmente beeinflussbar sein.

Gemäß einer Ausführungsform ist der Lack ein erster Lack, welcher auf einem zweiten Lack angeordnet ist. Die Schicht des ersten Lackes wird folglich auch als Decklackschicht bezeichnet und die Geschichte des zweiten Lackes wird folglich auch als Basislackschicht bezeichnet. Gemäß einer Ausführungsform ist die Decklackschicht eine Klarlackschicht oder eine Decklackschicht, insbesondere auf Polyurethan-Basis. Gemäß einer weiteren Ausführungsform ist die Basislackschicht durch ein Epoxidsystem (beispielsweise ein ausgehärtetes Epoxidharz) oder allgemein durch einen Kunststoff gebildet.

Fig. 11 zeigt eine Aufsicht auf einen Teil einer Oberflächenstruktur 162 gemäß Ausführungsformen der hierin offenbarten Gegenstände.

Wie bereits oben erläutert, definiert die Oberflächenstruktur 162 eine Einhüllende, die hierin auch als Umfangslinie 168 bezeichnet wird. Ähnlich wie in den bereits vorstehend erläuterten Figuren ist die Oberflächenstruktur 162 in Fig. 11 lediglich schematisch durch eine Vielzahl von parallelen Linien dargestellt, wobei jede der Linien einen Graben 189 in der Oberfläche (in Fig. 11 nicht dargestellt) repräsentiert.

Fig. 12 und 13 zeigen eine Querschnittsansicht der Oberflächenstruktur 162 aus Fig. 11 entlang der Schnittlinien XII-XII bzw. XIII-XIII in Fig. 11. Die Zuordnung der entsprechenden Schnittlinien zu Fig. 12 von Fig. 13 ist ferner durch Pfeile 193 verdeutlicht.

Gemäß einer Ausführungsform weisen die parallelen Gräben 189 in einem Randbereich 192 (in Fig. 11 schraffiert dargestellt) eine geringere Tiefe auf, beispielsweise wie es sich aus der Zusammenschau der Fig. 11 mit Fig. 12 von Fig. 13 ergibt.

Die von einem Rand der Oberflächenstruktur zunehmende Tiefenerstreckung ist auch in Fig. 12 und Fig. 13 ersichtlich. Es sollte sich verstehen, dass, sofern bei einem Prozentsatz von 80 % der maximalen Tiefenerstreckung die Oberflächenstruktur keine Vertiefung aufweist, die zweite Position 199, welche 80 % der maximalen Tiefenerstreckung entspricht, auch durch Interpolation oder Extrapolation ermittelt werden kann. Gemäß einer Ausführungsform kann beispielsweise vorgesehen sein, dass ausgehend von der ersten Position die zweite Position in einer Richtung entlang des größten Gradienten der Tiefenerstreckung der Oberflächenstruktur bestimmt wird.

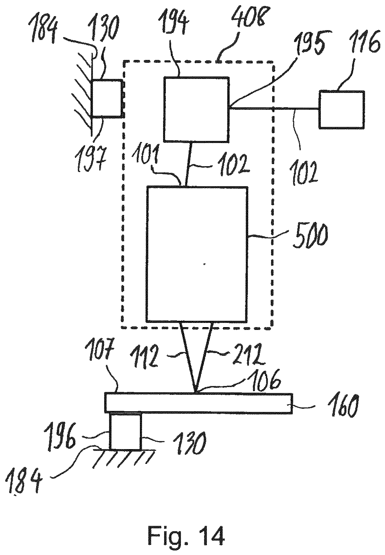

Fig. 14 zeigt eine Laserbearbeitungsvorrichtung 408 gemäß Ausführungsformen der hierin offenbarten Gegenstände.

Gemäß einer Ausführungsform weist die Laserbearbeitungsvorrichtung 408 eine optische Anordnung 500 auf, die gemäß einer oder mehreren der hierin offenbarten Ausführungsformen ausgebildet ist.

Gemäß einer weiteren Ausführungsform weist die Laserbearbeitungsvorrichtung 408 eine Scanvorrichtung 194 auf, welche beispielsweise eine Aktoranordnung und mindestens einen bewegbaren Spiegel gemäß Ausführungsformen der hierin offenbarten Gegenstände aufweisen kann. Gemäß einer Ausführungsform ist die Scanvorrichtung 194 durch einen Galvanometerscanner gebildet. Gemäß einer Ausführungsform ist die Scanvorrichtung 194 eingerichtet, um einen Laserstrahl 102 auf einen Eingang 101 der optischen Anordnung 500 zu richten, bzw. den Laserstrahl 102 über den Eingang 101 der optischen Anordnung 500 zu bewegen.

Gemäß einer weiteren Ausführungsform weist die Laserbearbeitungsvorrichtung 408 einen Lasereingang 195 auf, welcher mit einer Laserquelle 116 koppelbar ist. Gemäß einer Ausführungsform ist der Lasereingang 195 von der Scanvorrichtung 194 gebildet, beispielsweise wie in Fig. 14 dargestellt. Gemäß einer Ausführungsform ist die Laserquelle 116 extern zu der Laserbearbeitungsvorrichtung 408. Falls beispielsweise die Laserbearbeitungsvorrichtung 408 an einem Roboterarm montiert ist, kann die Laserquelle 116 neben dem Roboterarm am Boden positioniert und mit dem Lasereingang 195 optisch gekoppelt sein. Gemäß einer weiteren Ausführungsform (in Fig. 14 nicht dargestellt) ist die Laserquelle 116 ein Teil der Laserbearbeitungsvorrichtung 408.

Gemäß einer Ausführungsform erzeugt die optische Anordnung aus dem Laserstrahl 102 mindestens zwei Teilstrahlen 112, 212, die in einem Laserspot 106 ein Interferenzmuster erzeugen.

Gemäß einer Ausführungsform ist ein Objekt 160 bezüglich der optischen Anordnung 500 so positioniert, dass der Laserspot 106 auf einer Oberfläche 107 des Objekts 160 positioniert ist.

Gemäß einer Ausführungsform ist der Laserbearbeitungsvorrichtung eine weitere Aktoranordnung 130 zugeordnet, mit welcher die optische Anordnung 500 und das Objekt 160 relativ zueinander bewegbar sind, beispielsweise um einen Oberflächenabschnitt des Objekts 160 zu strukturieren, der allein durch ein Bewegen des Laserstrahles 102 über den Eingang 101 der optischen Anordnung 500 nicht abgedeckt werden kann.

Gemäß einer Ausführungsform weist die weitere Aktoranordnung 130 mindestens einen ersten Aktor 196 auf, mit welchem das Objekt 160 bezüglich eines Bezugspunktes 184 bewegbar ist. Gemäß einer Ausführungsform weist die weitere Aktoranordnung 130 ferner mindestens einen zweiten Aktor 197 auf, mit welchem die Laserbearbeitungsvorrichtung 408 bezüglich des Bezugspunktes 184 bewegbar ist. Gemäß einer Ausführungsform ist der mindestens eine zweite Aktor 197 durch einen Roboterarm gebildet.

Es sollte angemerkt werden, dass hierin offenbarte Entitäten (wie beispielsweise eine Vorrichtung, ein Merkmal, ein Verfahrensschritt, eine Steuervorrichtung, eine Aktoranordnung, eine optische Anordnung, ein Aktor, ein optisches Element, etc. nicht auf die dezidierten Entitäten beschränkt sind, wie sie in einigen Ausführungsformen beschrieben sind. Vielmehr können die hierin offenbarten Gegenstände auf verschiedene Weisen implementiert werden, während sie immer noch die offenbarte spezifische Funktionalität liefern.

Insbesondere können die hierin beschriebenen Gegenstände auf verschiedene Weisen mit verschiedener Granularität auf Vorrichtungs-Niveau, auf Verfahrens-Niveau, oder auf Software-Niveau bereitgestellt sein, während sie immer noch die angegebene Funktionalität liefern. Ferner sollte angemerkt werden, dass gemäß Ausführungsformen eine separate Entität für jede der hierin offenbarten Funktionen bereitgestellt sein kann. Gemäß anderer Ausführungsformen kann eine Entität konfiguriert sein, um zwei oder mehr Funktionen, wie sie hierin beschrieben sind, zu liefern. Beispielsweise kann die Funktion der beiden Spiegel 214 in Fig. 2 gemäß einer Ausführungsform durch einen einzigen Dachkantenspiegel realisiert sein. Gemäß nochmals anderen Ausführungsformen können zwei oder mehr Entitäten konfiguriert sein, um zusammen eine Funktion, wie sie hierin beschrieben ist, zu liefern.

Es wird darauf hingewiesen, dass die hier beschriebenen Implementierungen in den Zeichnungen lediglich eine beschränkte Auswahl an möglichen Ausführungsvarianten der hierin offenbarten Gegenstände darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offenbart anzusehen sind. Ferner sollte erwähnt werden, dass Begriffe wie "ein" oder "eines" eine Mehrzahl nicht ausschließen. Begriffe wie "enthaltend" oder "aufweisend" schließen weitere Merkmale oder Verfahrensschritte nicht aus. Die Begriffe "aufweisend" oder "enthaltend" oder "umfassend" umfassen jeweils die beiden Bedeutungen "unter anderem aufweisend" und "bestehend aus".

Ferner sollte angemerkt werden, dass, während die exemplarischen Gegenstände und Elemente (zum Beispiel Laserbearbeitungsvorrichtungen, optische Anordnungen, etc.) in den Zeichnungen eine bestimmte Kombination von mehreren Ausführungsformen der hierin offenbarten Gegenstände zeigt, jede andere Kombination von Ausführungsformen ebenso möglich und mit dieser Anmeldung als offenbart anzusehen ist.

Eine vorteilhafte Kombination von Ausführungsformen der hierin offenbarten Gegenstände lässt sich wie folgt zusammenfassen:

Eine Laserbearbeitungsvorrichtung weist auf: eine optische Anordnung; wobei die optische Anordnung einen Eingang aufweist zum Empfangen eines Laserstrahls; wobei die optische Anordnung einen Strahlteiler aufweist, welcher den Laserstrahl in mindestens zwei Teilstrahlen teilt; wobei die optische Anordnung die Teilstrahlen wieder zu einem Laserspot zusammenführt zur Erzeugung eines Interferenzmusters in dem Laserspot; wobei ein erster Zustand des Laserstrahls an dem Eingang ein erstes Interferenzmuster erzeugt und ein zweiter Zustand des Laserstrahls ein zweites Interferenzmuster erzeugt; wobei der erste Zustand und der zweite Zustand sich in mindestens einem von (i) einer Position des Laserstahls an dem Eingang und (ii) einem Einfallswinkel des Laserstrahls bezüglich des Eingangs unterscheiden; und wobei die optische Anordnung konfiguriert ist, so dass das zweite Interferenzmuster das erste Interferenzmuster in Phase fortsetzt.

## Patentansprüche

1. Laserbearbeitungsvorrichtung (125, 225, 308, 408) aufweisend:

eine optische Anordnung (100, 200, 300, 400, 500);
mindestens einen beweglichen Spiegel (314) und eine Aktoranordnung (118) zur Steuerung von dem mindestens einen beweglichen Spiegel (314);
wobei die optische Anordnung (100, 200, 300, 400, 500) einen Eingang (101) aufweist zum Empfangen eines Laserstrahls (102);
wobei der mindestens eine bewegliche Spiegel (314) angeordnet ist, um einen Zustand des Laserstrahles an dem Eingang (101) zu ändern; und
wobei die optische Anordnung (100, 200, 300, 400, 500) einen Strahlteiler (110) aufweist, welcher den Laserstrahl (102) in mindestens zwei Teilstrahlen (104, 204) teilt;
und wobei die optische Anordnung (100, 200, 300, 400, 500) die Teilstrahlen (104, 204) wieder zu einem Laserspot (106) zusammenführt zur Erzeugung eines Interferenzmusters (108, 208) in dem Laserspot (106);
wobei eine Änderung eines Einfallswinkels des Laserstrahls (102) bezüglich des Eingangs (101) und optional zusätzlich eine Änderung einer Position des Laserstrahls (102) an dem Eingang (101) mindestens eines von dem folgenden bewirkt:

(i) eine Abstandsänderung DP eines Abstands (141, 241) zwischen einem Zentrum (132) des Laserspots (106) und einem in einer vorbestimmten Richtung (144) nächstliegenden Interferenzmaximum (240) des Interferenzmusters (108, 208),
(ii) eine Positionsänderung DS einer Position (134, 136) des Zentrums (132) des Laserspots (106);

wobei die optische Anordnung (100, 200, 300, 400, 500) so konfiguriert ist, dass eine Bedingung

$$|DS| + |DP| = n*L$$

für eine kontinuierliche Positionsänderung DS gilt, und
wobei n eine natürliche Zahl ist;
wobei L ein Abstand zwischen zwei benachbarten Interferenzmaxima (140, 240, 340) des Interferenzmusters (108, 208) in der vorbestimmten Richtung (144) ist, einschließlich eines Toleranzbereichs von ± 5 %; und
wobei die Abstandsänderung DP definiert ist durch eine Differenz von einem ersten Abstand (141) und einem zweiten Abstand (241); und
wobei jeder von dem ersten Abstand (141) und dem zweiten Abstand (241) in der vorbestimmten Richtung (144) definiert ist.

2. Laserbearbeitungsvorrichtung (125, 225, 308, 408) nach Anspruch 1, wobei

ein erster Zustand des Laserstrahls (102) an dem Eingang (101) eine erste Position P1 (134) des Zentrums (132) des Laserspots (106) und ein erstes Interferenzmuster (108) definiert;

ein zweiter Zustand des Laserstrahls (102) an dem Eingang (101) eine zweite Position P2 (136) des Zentrums (132) des Laserspots (106) und ein zweites Interferenzmuster (208) definiert;

ein Paar von Teilstrahlen (104, 204) der mindestens zwei Teilstrahlen (104, 204) in dem ersten Zustand eine erste optische Weglängendifferenz DI_A aufweist;

das Paar von Teilstrahlen (104, 204) in dem zweiten Zustand eine zweite optische Weglängendifferenz DI_B aufweist;

die optische Anordnung (100, 200, 300, 400, 500) für die Positionsänderung DS = P1 - P2 eine Differenz DI_AB = DI_A - DI_B zwischen der ersten optischen Weglängendifferenz und der zweiten optischen Weglängendifferenz liefert, welche eine Abstandsänderung DP bewirkt, so dass das zweite Interferenzmuster (208) das erste Interferenzmuster (108) in Phase fortsetzt.

3. Laserbearbeitungsvorrichtung (125, 225, 308, 408) nach irgendeinem der Ansprüche 1 oder 2,

wobei die Bedingung mindestens bis zu einem Positionsänderungswert gilt, der gleich dem Durchmesser des Laserspots (106) ist;

und/oder

wobei der Eingang (101) einen ersten Bereich (119) und einen zweiten Bereich (121) aufweist, und wobei die Laserbearbeitungsvorrichtung eine Aktoranordnung (118) zum Positionieren des Laserstrahls (102) in dem ersten Bereich (119) und anschließend in dem zweiten Bereich (121) aufweist.

4. Laserbearbeitungsvorrichtung (125, 225, 308, 408) nach irgendeinem der vorhergehenden Ansprüche, wobei die optische Anordnung (100, 200, 300, 400, 500) mindestens ein optisches Element (150) aufweist, welches in Transmission arbeitet; insbesondere wobei eine Änderung eines Weglängenabschnitts (151) eines Strahlungsweges von jedem der Teilstrahlen (104, 204), dessen Strahlungsweg durch das optische Element verläuft, in dem optischen Element (150) kleiner ± 5%, insbesondere kleiner als ± 1% und ferner insbesondere kleiner als ± 0,5% ist, wobei die Änderung des Weglängenabschnitts (151) durch eine Zustandsänderung des Laserstrahls (102) an dem Eingang (101) hervorgerufen ist.

5. Laserbearbeitungsvorrichtung (125, 225, 308, 408) nach irgendeinem der Ansprüche 1 bis 3, wobei alle optischen Elemente der optischen Anordnung ausschließlich in Reflexion arbeiten.

6. Laserbearbeitungsvorrichtung (125, 225, 308, 408) nach irgendeinem der vorhergehenden Ansprüche, wobei der Strahlteiler (110) ein halbdurchlässiger Spiegel ist.

7. Laserbearbeitungsvorrichtung (125, 225, 308, 408) nach irgendeinem der Ansprüche 1 bis 4 und 6, wobei von jedem transmittierenden optischen Element der optischen Anordnung nach dem Strahlteiler (110) jedes durchstrahlte Flächenpaar (154, 156), welches sich in einem Strahlungsweg (112, 212) von mindestens einem der Teilstahlen (104, 204) befindet, einen Winkel (158) von höchstens 10 Grad einschließt, insbesondere einen Winkel (158) von höchstens 5 Grad.

8. Laserbearbeitungsvorrichtung (125, 225, 308, 408) nach irgendeinem der vorhergehenden Ansprüche, ferner aufweisend mindestens eines von dem Folgenden:

die optische Anordnung (100, 200, 300, 400, 500) weist nach dem Strahlteiler (110) kein Prisma auf;

der Laserstrahl (102) ist ein $CO_2$ Laserstrahl, insbesondere ein $CO_2$ Laserstrahl mit einer Leistung von mindestens 800 W;

die Laserbearbeitungsvorrichtung (108, 208, 308, 408) ist eingerichtet, um eine Lackoberfläche zu strukturieren.

9. Verfahren zur Interferenzstrukturierung einer Oberfläche, das Verfahren aufweisend:

Erzeugen eines ersten Interferenzmusters (108) auf der Oberfläche;
Erzeugen eines zweiten Interferenzmusters (208) auf der Oberfläche;

wobei das Erzeugen des ersten Interferenzmusters (108) und des zweiten Interferenzmusters (208) durch eine einzige optische Anordnung (100, 200, 300, 400, 500) erfolgt, welche einen Eingang (101) aufweist;

wobei das erste Interferenzmuster (108) und das zweite Interferenzmuster (208) durch die optische Anordnung (100, 200, 300, 400, 500) erzeugt werden, indem ein Einfallswinkel des Laserstrahls (102) bezüglich des Eingangs (101) und optional zusätzlich eine Position des Laserstrahls (102) an dem Eingang (101) verändert wird und hierdurch

(i) eine Abstandsänderung DP eines Abstands (141, 241) zwischen einem Zentrum (132) des Laserspots (106) und einem in einer vorbestimmten Richtung (144) nächstliegenden Interferenzmaximum (240) des Interferenzmusters (108, 208) erfolgt, und/oder

(ii) eine Positionsänderung DS einer Position des Zentrums (132) des Laserspots (106) erfolgt;

wobei die optische Anordnung (100, 200, 300, 400, 500) so konfiguriert ist, dass eine Bedingung

$$|DS| + |DP| = n*L$$

für eine kontinuierliche Positionsänderung DS erfüllt ist; und

wobei n eine natürliche Zahl ist;

L ein Abstand zwischen zwei benachbarten Interferenzmaxima (140, 240, 340) des ersten Interferenzmusters (108) in der vorbestimmten Richtung (144) ist, einschließlich eines Toleranzbereichs von ± 5 %; und

wobei die Abstandsänderung DP definiert ist durch eine Differenz von einem ersten Abstand (141) und einem zweiten Abstand (241); und

wobei jeder von dem ersten Abstand (141) und dem zweiten Abstand (241) in der vorbestimmten Richtung (144) definiert ist.

10. Verwendung einer optischen Anordnung zur Erzeugung eines ersten Interferenzmusters (108) und eines zweiten Interferenzmusters (208) durch Änderung eines Einfallswinkels des Laserstrahls (102) bezüglich des Eingangs (101) und optional zusätzlich durch Änderung einer Position des Laserstahls (102) an dem Eingang (101) und hierdurch Bewirken von mindestens einem von:

(i) einer Abstandsänderung DP eines Abstands (141, 241) zwischen einem Zentrum (132) des Laserspots (106) und einem in einer vorbestimmten Richtung (144) nächstliegenden Interferenzmaximum (240) des Interferenzmusters (108, 208),

(ii) einer Positionsänderung DS einer Position des Zentrums (132) des Laserspots (106);

wobei die optische Anordnung (100, 200, 300, 400, 500) so konfiguriert ist, dass eine Bedingung

$$|DS| + |DP| = n*L$$

für eine kontinuierliche Positionsänderung DS gilt; und

wobei n eine natürliche Zahl ist;

L ein Abstand zwischen zwei benachbarten Interferenzmaxima (140, 240, 340) des Interferenzmusters (108, 208) in der vorbestimmten Richtung (144) ist, einschließlich eines Toleranzbereichs von ± 5 %; und

wobei die Abstandsänderung DP definiert ist durch eine Differenz von einem ersten Abstand (141) und einem zweiten Abstand (241); und

wobei jeder von dem ersten Abstand (141) und dem zweiten Abstand (241) in der vorbestimmten Richtung (144) definiert ist.

11. Laserbearbeitungsvorrichtung (125, 225, 308, 408) aufweisend:

eine optische Anordnung (100, 200, 300, 400, 500);

mindestens einen beweglichen Spiegel (314) und eine Aktoranordnung (118) zur Steuerung von dem mindestens einen beweglichen Spiegel (314);

wobei die optische Anordnung (100, 200, 300, 400, 500) einen Eingang (101) aufweist zum Empfangen eines Laserstrahls (102);

wobei der mindestens eine bewegliche Spiegel (314) angeordnet ist, um einen Zustand des Laserstrahles an dem Eingang (101) zu ändern;

wobei die optische Anordnung (100, 200, 300, 400, 500) einen Strahlteiler (110) aufweist, welcher den Laserstrahl (102) in mindestens zwei Teilstrahlen (104, 204) teilt;

wobei die optische Anordnung (100, 200, 300, 400, 500) die Teilstrahlen (104, 204) wieder zu einem Laserspot (106) zusammenführt zur Erzeugung eines Interferenzmusters (108, 208) in dem Laserspot (106);

wobei ein erster Zustand des Laserstrahls (102) an dem Eingang (101) ein erstes Interferenzmuster erzeugt und ein zweiter Zustand des Laserstrahls (102) ein zweites Interferenzmuster erzeugt;

wobei der erste Zustand und der zweite Zustand sich in einem Einfallswinkel des Laserstrahls (102) bezüglich des Eingangs (101) und optional zusätzlich in einer Position des Laserstahls an dem Eingang (101) unterscheiden; und

wobei die optische Anordnung (100, 200, 300, 400, 500) konfiguriert ist, so dass das zweite Interferenzmuster das erste Interferenzmuster in Phase fortsetzt.

12. Laserbearbeitungsvorrichtung (125, 225, 308, 408) aufweisend:

eine optische Anordnung (100, 200, 300, 400, 500);

mindestens einen beweglichen Spiegel (314) und eine Aktoranordnung (118) zur Steuerung von dem mindestens einen beweglichen Spiegel (314);

wobei die optische Anordnung (100, 200, 300, 400, 500) einen Eingang (101) aufweist zum Empfangen eines Laserstrahls (102);

wobei der mindestens eine bewegliche Spiegel (314) angeordnet ist, um einen Zustand des Laserstrahles an dem Eingang (101) zu ändern;

wobei die optische Anordnung (100, 200, 300, 400, 500) einen Strahlteiler (110) aufweist, welcher den Laserstrahl (102) in mindestens zwei Teilstrahlen (104, 204) teilt;

wobei die optische Anordnung (100, 200, 300, 400, 500) die Teilstrahlen (104, 204) wieder zu einem Laserspot (106) zusammenführt zur Erzeugung eines Interferenzmusters (108, 208) in dem Laserspot (106);

wobei ein erster Zustand des Laserstrahls (102) an dem Eingang (101) ein erstes Interferenzmuster erzeugt und ein zweiter Zustand des Laserstrahls (102) ein zweites Interferenzmuster erzeugt;

wobei der erste Zustand und der zweite Zustand sich in einem Einfallswinkel des Laserstrahls (102) bezüglich des Eingangs (101) und optional zusätzlich in einer Position des Laserstahls an dem Eingang (101) unterscheiden;

wobei ein Zentrum (132) des ersten Interferenzmusters (108) und ein Zentrum (132) des zweiten Interferenzmusters (208) einen Abstand aufweisen, der mindestens dem einfachen Durchmesser des Laserspots (106) entspricht, insbesondere mindestens dem fünffachen Durchmesser des Laserspots (106), ferner insbesondere mindestens dem zehnfachen Durchmesser des Laserspots (106);

wobei eine Änderung einer Weglänge eines Strahlungsweges von jedem der Teilstrahlen (104, 204) aufgrund der Zustandsänderung von dem ersten Zustand zu dem zweiten Zustand kleiner als ± 5% der gesamten Weglänge des Strahlungsweges von dem Strahlteiler (110) bis zu dem Laserspot (106) ist, insbesondere kleiner als ± 1% und ferner insbesondere kleiner als ± 0,5% ist.

13. Objekt (160, 260, 360) mit einer Oberfläche (107), welche eine periodische Oberflächenstruktur (162) aufweist, wobei die Oberflächenstruktur (162) eine Umfangslinie (168) definiert, welche eine Einhüllende der Oberflächenstruktur (162) ist, und wobei die Umfangslinie (168) mindestens abschnittsweise in einem Umfangslinienabschnitt (170, 172, 185, 186) eine Form aufweist, die eine periodische Wiederholung eines Grundelementes (171, 183, 187) ist, und wobei sich eine Periodizität der Oberflächenstruktur (162) von einer Periodizität des Umfangslinienabschnitts (170, 172, 185, 186) unterscheidet;

wobei die Umfangslinie (168) durch überlappende Bearbeitungsspots (169) definiert ist,

wobei die Bearbeitungsspots (169) einen ersten Bearbeitungsspot und einen zweiten Bearbeitungsspot umfassen;

wobei die Oberflächenstruktur eine Vielzahl von parallelen Gräben aufweist;

wobei die Oberflächenstruktur des zweiten Bearbeitungsspots die Oberflächenstruktur des ersten Bearbeitungsspots in Phase fortsetzt;

wobei ein erster Abstand zwischen einem Zentrum des ersten Bearbeitungsspots (169) und einem in einer vorbestimmten Richtung nächstliegenden Graben sich von einem zweiten Abstand zwischen einem Zentrum des zweiten Bearbeitungsspots (169) und einem in der vorbestimmten Richtung nächstliegenden Graben unterscheidet.

14. Objekt (160, 260, 360) gemäß Anspruch 13, wobei der Oberflächenstruktur (162) mindestens eines der folgenden Merkmale aufweist:

- das Grundelement weist mindestens einen bogenförmigen Abschnitt auf;
- der Umfangslinienabschnitt ist ein erster Umfangslinienabschnitt (170, 185), das Grundelement ist ein erstes Grundelement (171, 183) und die Umfangslinie (168) weist einen zweiten Umfangslinienabschnitt (172, 186) auf, welcher dem ersten Umfangslinienabschnitt (170, 185) gegenüberliegt.

15. Objekt (160, 260, 360) mit einer Oberfläche, wobei

die Oberfläche (107) eine Oberflächenstruktur (162) aufweist;
die Oberflächenstruktur (162) die eine maximale Tiefenerstreckung (190) bezüglich der Oberfläche (107) hat;
eine Tiefenerstreckung der Oberflächenstruktur (162) von einer ersten Position (198) an einem Rand der Oberflächenstruktur (162) bis zu einer zweiten Position (199) auf 80 % der maximalen Tiefenerstreckung (190) zunimmt; und
ein Abstand (163) zwischen der ersten Position (198) und der zweiten Position (199) mindestens 100 $\mu$m beträgt.

**Claims**

1. A laser processing device (125, 225, 308, 408) comprising:

an optical arrangement (100, 200, 300, 400, 500);
at least one movable mirror (314) and an actuator arrangement (118) for controlling the at least one movable mirror (314);
wherein the optical arrangement (100, 200, 300, 400, 500) comprises an input (101) for receiving a laser beam (102);
wherein the at least one movable mirror (314) is arranged to change a state of the laser beam at the input (101); and
wherein the optical arrangement (100, 200, 300, 400, 500) comprises a beam splitter (110) which splits the laser beam (102) into at least two partial beams (104, 204);
and wherein the optical arrangement (100, 200, 300, 400, 500) recombines the partial beams (104, 204) into a laser spot (106) for generating an interference pattern (108, 208) in the laser spot (106);
wherein a change of an angle of incidence of the laser beam (102) with respect to the input (101) and optionally additionally a change of a position of the laser beam (102) at the input (101) causes at least one of the following:

(i) a distance change DP of a distance (141, 241) between a center (132) of the laser spot (106) and an interference maximum (240) of the interference pattern (108, 208) nearest in a predetermined direction (144),
(ii) a position change DS of a position (134, 136) of the center (132) of the laser spot (106);

wherein the optical arrangement (100, 200, 300, 400, 500) is configured such that a condition

$$|DS| + |DP| = n*L$$

is valid for a continuous position change DS, and
wherein n is a natural number;
wherein L is a distance between two adjacent interference maxima (140, 240, 340) of the interference pattern (108, 208) in the predetermined direction (144), including a tolerance range of $\pm$ 5%; and
wherein the distance change DP is defined by a difference of a first distance (141) and a second distance (241); and
wherein each of the first distance (141) and the second distance (241) is defined in the predetermined direction (144).

2. The laser processing device (125, 225, 308, 408) according to claim 1, wherein

a first state of the laser beam (102) at the input (101) defines a first position P1 (134) of the center (132) of the laser spot (106) and a first interference pattern (108);
a second state of the laser beam (102) at the input (101) defines a second position P2 (136) of the center (132) of the laser spot (106) and a second interference pattern (208);
a pair of partial beams (104, 204) of the at least two partial beams (104, 204) in the first state has a first optical path length difference DI_A;
the pair of partial beams (104, 204) in the second state has a second optical path length difference DI_B;
the optical arrangement (100, 200, 300, 400, 500) for the position change DS = P1 - P2 provides a difference DI_AB = DI_A - DI_B between the first optical path length difference and the second optical path length difference which causes a distance change DP such that the second interference pattern (208) continues the first interference pattern (108) in phase.

3. The laser processing device (125, 225, 308, 408) according to any one of claims 1 or 2,

   wherein the condition applies at least up to a position change value equal to the diameter of the laser spot (106); and/or
   wherein the input (101) comprises a first region (119) and a second region (121), and wherein the laser processing device comprises an actuator arrangement (118) for positioning the laser beam (102) in the first region (119) and subsequently in the second region (121).

4. The laser processing device (125, 225, 308, 408) according to any one of the preceding claims, wherein the optical arrangement (100, 200, 300, 400, 500) comprises at least one optical element (150) which operates in transmission; in particular wherein a change of a path length section (151) of a radiation path of each of the partial beams (104, 204), the radiation path of which runs through the optical element, in the optical element (150) is smaller than $\pm$ 5%, in particular smaller than $\pm$ 1% and further in particular smaller than $\pm$ 0.5%, wherein the change of the path length section (151) is caused by a change of state of the laser beam (102) at the input (101).

5. The laser processing device (125, 225, 308, 408) according to any one of claims 1 to 3, wherein all optical elements of the optical arrangement operate exclusively in reflection.

6. The laser processing device (125, 225, 308, 408) according to any one of the preceding claims, wherein the beam splitter (110) is a semi-permeable mirror.

7. The laser processing device (125, 225, 308, 408) according to any one of claims 1 to 4 and 6, wherein of each transmitting optical element of the optical arrangement downstream of the beam splitter (110) each transirradiated surface pair (154, 156) which is located in a radiation path (112, 212) of at least one of the partial beams (104, 204) encloses an angle (158) of at most 10 degrees, in particular an angle (158) of at most 5 degrees.

8. The laser processing device (125, 225, 308, 408) according to any one of the preceding claims, further comprising at least one of the following:

   the optical arrangement (100, 200, 300, 400, 500) does not comprise a prism downstream of the beam splitter (110);
   the laser beam (102) is a CO2 laser beam, in particular a CO2 laser beam having a power of at least 800 W;
   the laser processing device (108, 208, 308, 408) is configured to pattern a lacquer surface.

9. A method for interference patterning a surface, the method comprising:

   generating a first interference pattern (108) on the surface;
   generating a second interference pattern (208) on the surface;
   wherein the generating of the first interference pattern (108) and the second interference pattern (208) is performed by a single optical arrangement (100, 200, 300, 400, 500) comprising an input (101);
   wherein the first interference pattern (108) and the second interference pattern (208) are generated by the optical arrangement (100, 200, 300, 400, 500) by changing an angle of incidence of the laser beam (102) with respect to the input (101) and optionally additionally a position of the laser beam (102) at the input (101) and thereby

   (i) a distance change DP of a distance (141, 241) between a center (132) of the laser spot (106) and an interference maximum (240) of the interference pattern (108, 208) nearest in a predetermined direction (144) occurs, and/or
   (ii) a position change DS of a position of the center (132) of the laser spot (106) occurs;

   wherein the optical arrangement (100, 200, 300, 400, 500) is configured such that a condition

$$|DS| + |DP| = n*L$$

is fulfilled for a continuous position change DS; and
wherein n is a natural number;
L is a distance between two adjacent interference maxima (140, 240, 340) of the first interference pattern (108) in the predetermined direction (144), including a tolerance range of ± 5%; and
wherein the distance change DP is defined by a difference of a first distance (141) and a second distance (241); and
wherein each of the first distance (141) and the second distance (241) is defined in the predetermined direction (144).

10. Use of an optical arrangement for generating a first interference pattern (108) and a second interference pattern (208) by changing an angle of incidence of the laser beam (102) with respect to the input (101) and optionally additionally by changing a position of the laser beam (102) at the input (101) and thereby causing at least one of:

(i) a distance change DP of a distance (141, 241) between a center (132) of the laser spot (106) and an interference maximum (240) of the interference pattern (108, 208) nearest in a predetermined direction (144),
(ii) a position change DS of a position of the center (132) of the laser spot (106);
wherein the optical arrangement (100, 200, 300, 400, 500) is configured such that a condition

$$|DS| + |DP| = n*L$$

is valid for a continuous position change DS; and
wherein n is a natural number;
L is a distance between two adjacent interference maxima (140, 240, 340) of the interference pattern (108, 208) in the predetermined direction (144), including a tolerance range of ± 5%; and
wherein the distance change DP is defined by a difference of a first distance (141) and a second distance (241); and
wherein each of the first distance (141) and the second distance (241) is defined in the predetermined direction (144).

11. A laser processing device (125, 225, 308, 408) comprising:

an optical arrangement (100, 200, 300, 400, 500);
at least one movable mirror (314) and an actuator arrangement (118) for controlling the at least one movable mirror (314);
wherein the optical arrangement (100, 200, 300, 400, 500) comprises an input (101) for receiving a laser beam (102);
wherein the at least one movable mirror (314) is arranged to change a state of the laser beam at the input (101);
wherein the optical arrangement (100, 200, 300, 400, 500) comprises a beam splitter (110) which splits the laser beam (102) into at least two partial beams (104, 204);
wherein the optical arrangement (100, 200, 300, 400, 500) recombines the partial beams (104, 204) into a laser spot (106) for generating an interference pattern (108, 208) in the laser spot (106);
wherein a first state of the laser beam (102) at the input (101) generates a first interference pattern and a second state of the laser beam (102) generates a second interference pattern;
wherein the first state and the second state differ in an angle of incidence of the laser beam (102) with respect to the input (101) and optionally additionally in a position of the laser beam at the input (101); and
wherein the optical arrangement (100, 200, 300, 400, 500) is configured such that the second interference pattern continues the first interference pattern in phase.

12. A laser processing device (125, 225, 308, 408) comprising:

an optical arrangement (100, 200, 300, 400, 500);
at least one movable mirror (314) and an actuator arrangement (118) for controlling the at least one movable mirror (314);
wherein the optical arrangement (100, 200, 300, 400, 500) comprises an input (101) for receiving a laser beam (102);

wherein the at least one movable mirror (314) is arranged to change a state of the laser beam at the input (101);

wherein the optical arrangement (100, 200, 300, 400, 500) comprises a beam splitter (110) which splits the laser beam (102) into at least two partial beams (104, 204);

wherein the optical arrangement (100, 200, 300, 400, 500) recombines the partial beams (104, 204) into a laser spot (106) for generating an interference pattern (108, 208) in the laser spot (106);

wherein a first state of the laser beam (102) at the input (101) generates a first interference pattern and a second state of the laser beam (102) generates a second interference pattern;

wherein the first state and the second state differ in an angle of incidence of the laser beam (102) with respect to the input (101) and optionally additionally in a position of the laser beam at the input (101);

wherein a center (132) of the first interference pattern (108) and a center (132) of the second interference pattern (208) have a distance corresponding to at least one time the diameter of the laser spot (106), in particular at least five times the diameter of the laser spot (106), further in particular at least ten times the diameter of the laser spot (106);

wherein a change of a path length of a radiation path of each of the partial beams (104, 204) due to the change of state from the first state to the second state is smaller than $\pm$ 5% of the total path length of the radiation path from the beam splitter (110) to the laser spot (106), in particular smaller than $\pm$ 1% and further in particular smaller than $\pm$ 0.5%.

13. An object (160, 260, 360) having a surface (107) comprising a periodic surface structure (162), wherein the surface structure (162) defines a circumferential line (168) which is an envelope of the surface structure (162), and wherein the circumferential line (168) comprises, at least in sections in a circumferential line section (170, 172, 185, 186), a shape which is a periodic repetition of a base element (171, 183, 187), and wherein a periodicity of the surface structure (162) differs from a periodicity of the circumferential line section (170, 172, 185, 186);

wherein the circumferential line (168) is defined by overlapping processing spots (169), wherein the processing spots (169) comprise a first processing spot and a second processing spot;

wherein the surface structure comprises a plurality of parallel trenches; wherein the surface structure of the second processing spot continues the surface structure of the first processing spot in phase;

wherein a first distance between a center of the first processing spot (169) and a trench nearest in a predetermined direction differs from a second distance between a center of the second processing spot (169) and a trench nearest in the predetermined direction.

14. The object (160, 260, 360) according to claim 13, wherein the surface structure (162) comprises at least one of the following features:

- the base element comprises at least one arcuated section;
- the circumferential line section is a first circumferential line section (170, 185), the base element is a first base element (171, 183), and the circumferential line (168) comprises a second circumferential line section (172, 186) which is opposite to the first circumferential line section (170, 185).

15. An object (160, 260, 360) having a surface, wherein

the surface (107) comprises a surface structure (162);

the surface structure (162) has a maximum depth extent (190) with respect to the surface (107);

a depth extent of the surface structure (162) increases from a first position (198) at an edge of the surface structure (162) to a second position (199) to 80% of the maximum depth extent (190); and

a distance (163) between the first position (198) and the second position (199) is at least 100 $\mu$m.

## Revendications

1. Dispositif d'usinage au laser (125, 225, 308, 408) présentant :

un dispositif optique (100, 200, 300, 400, 500) ;

au moins un miroir mobile (314) et un ensemble d'actionneurs (118) permettant de commander le au moins un miroir mobile (314) ;

dans lequel le dispositif optique (100, 200, 300, 400, 500) présente une entrée (101) permettant de recevoir un faisceau laser (102) ;

dans lequel le au moins un miroir mobile (314) est agencé afin de modifier un état du faisceau laser au niveau de l'entrée (101) ; et

dans lequel le dispositif optique (100, 200, 300, 400, 500) présente un diviseur de faisceau (110) qui divise le faisceau laser (102) en au moins deux sous-faisceaux (104, 204) ;

et dans lequel le dispositif optique (100, 200, 300, 400, 500) réunit à nouveau les sous-faisceaux (104, 204) en un spot laser (106) afin de générer un motif d'interférence (108, 208) au sein du spot laser (106) ;

dans lequel une modification d'un angle d'incidence du faisceau laser (102) par rapport à l'entrée (101) et, de manière optionnelle et supplémentaire, une modification d'une position du faisceau laser (102) au niveau de l'entrée (101) provoque au moins une des actions ci-dessous :

(i) une modification de distance DP d'une distance (141, 241) entre un centre (132) du spot laser (106) et un plus proche maximum d'interférence (240) du motif d'interférence (108, 208) dans une direction prédéterminée (144),

(ii) une modification de position DS d'une position (134, 136) du centre (132) du spot laser (106) ;

dans lequel le dispositif optique (100, 200, 300, 400, 500) est configuré de sorte qu'une condition

$$|DS| + |DP| = n * L$$

pour une modification de position DS continue s'applique, et

dans lequel n est un nombre naturel ;

dans lequel L est une distance entre deux maxima d'interférence (140, 240, 340) adjacents du motif d'interférence (108, 208) dans la direction prédéterminée (144), en incluant une plage de tolérance de ± 5% ; et

dans lequel la modification de distance DP est définie grâce à la différence entre une première distance (141) et une seconde distance (241) ; et

dans lequel chacune parmi la première distance (141) et la seconde distance (241) est définie dans la direction prédéterminée (144).

2. Dispositif d'usinage au laser (125, 225, 308, 408) selon la revendication 1, dans lequel

un premier état du faisceau laser (102) au niveau de l'entrée (101) définit une première position P1 (134) du centre (132) du spot laser (106) et un premier motif d'interférence (108) ;

un second état du faisceau laser (102) au niveau de l'entrée (101) définit une seconde position P2 (136) du centre (132) du spot laser (106) et un second motif d'interférence (208) ;

une paire de sous-faisceaux (104, 204) des au moins deux sous-faisceaux (104, 204) présente dans le premier état une première différence de longueur de chemin optique DI_A ;

la paire de sous-faisceaux (104, 204) présente dans le second état une seconde différence de longueur de chemin optique DI_B ;

le dispositif optique (100, 200, 300, 400, 500) fournit pour la modification de position DS = P1 - P2 une différence DI_AB = DI_A - DI_B entre la première différence de longueur de chemin optique et la seconde différence de longueur de chemin optique, ce qui provoque une modification de distance DP, de sorte que le second motif d'interférence (208) prolonge en phase le premier motif d'interférence (108).

3. Dispositif d'usinage au laser (125, 225, 308, 408) selon l'une quelconque des revendications 1 ou 2,

dans lequel la condition s'applique au moins jusqu'à une valeur de modification de position, qui est égale au diamètre du spot laser (106) ;

et/ou

dans lequel l'entrée (101) présente une première région (119) et une seconde région (121), et dans lequel le dispositif d'usinage au laser présente un ensemble d'actionneurs (118) permettant de positionner le faisceau laser (102) dans la première région (119), puis dans la seconde région (121).

4. Dispositif d'usinage au laser (125, 225, 308, 408) selon l'une quelconque des revendications précédentes, dans lequel le dispositif optique (100, 200, 300, 400, 500) présente au moins un élément optique (150) qui fonctionne en transmission ; en particulier dans lequel une modification d'une partie de longueur de chemin (151) d'un chemin de rayonnement de chacun des sous-faisceaux (104, 204) dont le chemin de rayonnement traverse l'élément optique est inférieure à ± 5%, en particulier inférieure à ± 1% et de manière plus particulièrement préférée inférieure à ± 0,5%, dans lequel la modification de la partie de longueur de chemin (151) est provoquée par un modification d'état du faisceau laser (102) au niveau de l'entrée (101).

5. Dispositif d'usinage au laser (125, 225, 308, 408) selon l'une quelconque des revendications 1 à 3, dans lequel tous les éléments optiques du dispositif optique fonctionnent exclusivement en réflexion.

6. Dispositif d'usinage au laser (125, 225, 308, 408) selon l'une quelconque des revendications précédentes, dans lequel le diviseur de faisceau (110) est un miroir semi-transparent.

7. Dispositif d'usinage au laser (125, 225, 308, 408) selon l'une quelconque des revendications 1 à 4 et 6, dans lequel chaque paire de surfaces (154, 156) traversée par le rayonnement et se trouvant sur un chemin de rayonnement (112, 212) d'au moins un des sous-faisceaux (104, 204) forme avec l'élément optique fonctionnant en transmission un angle (158) d'au plus 10 degrés, en particulier un angle (158) d'au plus 5 degrés, après le diviseur de faisceau (110).

8. Dispositif d'usinage au laser (125, 225, 308, 408) selon l'une quelconque des revendications précédentes, comprenant en outre au moins un des éléments ci-dessous :

le dispositif optique (100, 200, 300, 400, 500) ne présente pas de prisme après le diviseur de faisceau (110) ;
le faisceau laser (102) est un faisceau laser CO2, en particulier un faisceau laser CO2 d'une puissance d'au moins 800 W ;
le dispositif d'usinage au laser (108, 208, 308, 408) est conçu pour structurer une surface de peinture.

9. Procédé de structuration d'interférence d'une surface, le procédé comprenant les étapes consistant à :

créer un premier motif d'interférence (108) sur la surface ;
créer un second motif d'interférence (208) sur la surface ;
dans lequel la génération du premier motif d'interférence (108) et du second motif d'interférence (208) intervient grâce à un seul dispositif optique (100, 200, 300, 400, 500) présentant une entrée (101) ;
dans lequel le premier motif d'interférence (108) et le second motif d'interférence (208) sont générés grâce au dispositif optique (100, 200, 300, 400, 500) en modifiant un angle d'incidence du faisceau laser (102) par rapport à l'entrée (101) et, de manière optionnelle et supplémentaire, une position du faisceau laser (102) au niveau de l'entrée (101) et grâce à cela

(i) une modification de distance DP d'une distance (141, 241) entre un centre (132) du spot laser (106) et un plus proche maximum d'interférence (240), dans une direction prédéterminée (144), du motif d'interférence (108, 208) intervient, et/ou
(ii) une modification de position DS d'une position du centre (132) du spot laser (106) intervient ;

dans lequel le dispositif optique (100, 200, 300, 400, 500) est configuré de sorte qu'une condition

$$|DS| + |DP| = n * L$$

pour une modification de position DS continue est remplie ; et
dans lequel n est un nombre naturel ;
dans lequel L est une distance entre deux maxima d'interférence (140, 240, 340) adjacents du premier motif d'interférence (108, 208) dans la direction prédéterminée (144), en incluant une plage de tolérance de ± 5% ; et
dans lequel la modification de distance DP est définie grâce à la différence entre une première distance (141) et une seconde distance (241) ; et
dans lequel chacune parmi la première distance (141) et la seconde distance (241) est définie dans la direction prédéterminée (144).

10. Utilisation d'un dispositif optique pour générer un premier motif d'interférence (108) et un second motif d'interférence (208) grâce à la modification d'un angle d'incidence du faisceau laser (102) par rapport à l'entrée (101) et, de manière optionnelle et supplémentaire, grâce à la modification d'une position du faisceau laser (102) au niveau de l'entrée (101), ce qui provoque au moins une des actions ci-dessous :

(i) une modification de distance DP d'une distance (141, 241) entre un centre (132) du spot laser (106) et un plus proche maximum d'interférence (240) du motif d'interférence (108, 208) dans une direction prédéterminée (144), (ii) une modification de position DS d'une position du centre (132) du spot laser (106) ;

dans lequel le dispositif optique (100, 200, 300, 400, 500) est configuré de sorte qu'une condition

$$|DS| + |DP| = n * L$$

pour une modification de position DS continue s'applique, et

dans lequel n est un nombre naturel ;

dans lequel L est une distance entre deux maxima d'interférence (140, 240, 340) adjacents du motif d'interférence (108, 208) dans la direction prédéterminée (144), en incluant une plage de tolérance de $\pm$ 5% ; et

dans lequel la modification de distance DP est définie grâce à la différence entre une première distance (141) et une seconde distance (241) ; et

dans lequel chacune parmi la première distance (141) et la seconde distance (241) est définie dans la direction prédéterminée (144).

11. Dispositif d'usinage au laser (125, 225, 308, 408) présentant :

un dispositif optique (100, 200, 300, 400, 500) ;

au moins un miroir mobile (314) et un ensemble d'actionneurs (118) permettant de commander le au moins un miroir mobile (314) ;

dans lequel le dispositif optique (100, 200, 300, 400, 500) présente une entrée (101) permettant de recevoir un faisceau laser (102) ;

dans lequel le au moins un miroir mobile (314) est agencé afin de modifier un état du faisceau laser au niveau de l'entrée (101) ; et

dans lequel le dispositif optique (100, 200, 300, 400, 500) présente un diviseur de faisceau (110) qui divise le faisceau laser (102) en au moins deux sous-faisceaux (104, 204) ;

dans lequel le dispositif optique (100, 200, 300, 400, 500) réunit à nouveau les sous-faisceaux (104, 204) en un spot laser (106) afin de générer un motif d'interférence (108, 208) dans le spot laser (106) ;

dans lequel un premier état du faisceau laser (102) génère un premier motif d'interférence au niveau de l'entrée (101) et un second état du faisceau laser (102) génère un second motif d'interférence ;

dans lequel le premier état et le second état diffèrent par l'angle d'incidence du faisceau laser (102) par rapport à l'entrée (101) et, de manière optionnelle et supplémentaire, par la position du faisceau laser au niveau de l'entrée (101) ; et

dans lequel le dispositif optique (100, 200, 300, 400, 500) est configuré de sorte que le second motif d'interférence prolonge en phase le premier motif d'interférence.

12. Dispositif d'usinage au laser (125, 225, 308, 408) présentant :

un dispositif optique (100, 200, 300, 400, 500) ;

au moins un miroir mobile (314) et un ensemble d'actionneurs (118) permettant de commander le au moins un miroir mobile (314) ;

dans lequel le dispositif optique (100, 200, 300, 400, 500) présente une entrée (101) permettant de recevoir un faisceau laser (102) ;

dans lequel le au moins un miroir mobile (314) est agencé afin de modifier un état du faisceau laser au niveau de l'entrée (101) ; et

dans lequel le dispositif optique (100, 200, 300, 400, 500) présente un diviseur de faisceau (110) qui divise le faisceau laser (102) en au moins deux sous-faisceaux (104, 204) ;

dans lequel le dispositif optique (100, 200, 300, 400, 500) réunit à nouveau les sous-faisceaux (104, 204) en un spot laser (106) afin de générer un motif d'interférence (108, 208) dans le spot laser (106) ;

dans lequel un premier état du faisceau laser (102) génère un premier motif d'interférence au niveau de l'entrée (101) et un second état du faisceau laser (102) génère un second motif d'interférence ;

dans lequel le premier état et le second état diffèrent par l'angle d'incidence du faisceau laser (102) par rapport à l'entrée (101) et, de manière optionnelle et supplémentaire, par la position du faisceau laser au niveau de l'entrée (101) ; dans lequel un centre (132) du premier motif d'interférence (108) et un centre (132) du second motif d'interférence (208) présentent une distance qui correspond au moins au diamètre simple du spot laser (106), en particulier au moins au quintuple du diamètre du spot laser (106), de manière plus particulièrement préférée au moins au décuple du diamètre du spot laser (106) ;

dans lequel une modification d'une longueur de chemin d'un chemin de rayonnement de chacun des sous-faisceaux (104, 204) en raison de la modification d'état entre le premier état et le second état est inférieure à ± 5%, en particulier inférieure à ± 1% et de manière plus particulièrement préférée inférieure à ± 0,5%, de la longueur totale du chemin de rayonnement depuis le diviseur de faisceau (110) jusqu'au spot laser (106).

13. Objet (160, 260, 360) muni d'une surface (107) présentant une structure de surface (162) périodique, dans lequel la structure de surface (162) définit une ligne périphérique (168) qui est une enveloppe de la structure de surface (162), et dans lequel la ligne périphérique (168) présente au moins par sections, au sein d'une section de ligne périphérique (170, 172, 185, 186), une forme qui est une répétition périodique d'un élément de base (171, 183, 187), et dans lequel une périodicité de la structure de surface (162) diffère d'une périodicité de la section de ligne périphérique (170, 172, 185, 186) ;

dans lequel la ligne périphérique (168) est définie par des points d'usinage (169) qui se chevauchent,
dans lequel les points d'usinage (169) comprennent un premier point d'usinage et un second point d'usinage ;
dans lequel la structure de surface présente une pluralité de tranchées parallèles ;
dans lequel la structure de surface du second point d'usinage prolonge en phase la structure de surface du premier point d'usinage ;
dans lequel une première distance entre un centre du premier point d'usinage (169) et une tranchée la plus proche dans une direction prédéterminée est différente d'une seconde distance entre un centre du second point d'usinage (169) et une tranchée la plus proche dans la direction prédéterminée.

14. Objet (160, 260, 360) selon la revendication 13, dans lequel la structure de surface (162) présente au moins une des caractéristiques ci-dessous :

- l'élément de base présente au moins une section arquée ;
- la section de ligne périphérique est une première section de ligne périphérique (170, 185), l'élément de base est un premier élément de base (171, 183) et la ligne périphérique (168) présente une seconde section de ligne périphérique (172, 186) qui se trouve à l'opposé à la première section de ligne périphérique (170, 185).

15. Objet (160, 260, 360) muni d'une surface, dans lequel

la surface (107) présente une structure de surface (162) ;
la structure de surface (162) présente une extension de profondeur maximale (190) par rapport à la surface (107) ;
une extension de profondeur de la structure de surface (162) augmente à 80% de l'extension de profondeur maximale (190) entre une première position (198) située au niveau d'un bord de la structure de surface (162) et une seconde position (199) ; et
une distance (163) entre la première position (198) et la seconde position (199) est d'au moins 100 um.

Fig. 1

Fig. 5

Fig. 2

Fig. 3

Fig. 4

Fig. 6

Fig. 7

Fig. 8

32

Fig. 9

Fig. 10

Fig. 11

Fig. 12

Fig. 13

Fig. 14

34

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2018197555 A1
- JP 2006110587 A
- US 2008311531 A1
- US 2017261847 A1
- DE 19623352 A1